# EUROPEAN PATENT SPECIFICATION

(11) **EP 4 033 661 B1**
(45) Date of publication and mention of the grant of the patent: **24.01.2024**
(21) Application number: 21773264.3
(22) Date of filing: 24.05.2021
(51) Int. Cl.: H03K 5/13

(54) **CONTROL CIRCUIT AND DELAY CIRCUIT**
STEUERSCHALTUNG UND VERZÖGERUNGSSCHALTUNG
CIRCUIT DE COMMANDE ET CIRCUIT DE RETARD

(30) Priority: 25.11.2020 CN 202011340785
(43) Date of publication of application: 27.07.2022
(73) Proprietor: Changxin Memory Technologies, Inc., Hefei City, Anhui 230000 (CN)
(72) Inventor: ZHU, Lei, Hefei City, Anhui 230000 (CN)
(74) Representative: Lavoix
(86) International application number: PCT/CN2021/095459
(87) International publication number: WO 2022/110697

(56) References cited:
- CN-A- 1 216 880
- CN-A- 101 256 824
- CN-A- 102 291 105
- CN-A- 109 450 415
- JP-A- 2001 251 171
- JP-A- 2010 074 721
- US-A1- 2011 102 043
- US-A1- 2015 229 296

## Description

### TECHNICAL FIELD

This application relates to the technical field of integrated circuits, and in particular to, a control circuit and a delay circuit.

### BACKGROUND

At present, a delay circuit, which is a circuit capable of delaying a pulse signal for a certain period of time, is often used in semiconductor components,. When the delay circuit is used in a Dynamic Random Access Memory (DRAM), it is often necessary to accurately control delay time of the delay circuit. The delay circuit needs to meet the requirement of less change of the delay time when parameters such as power supply voltage, operating temperature, and manufacturing process change.

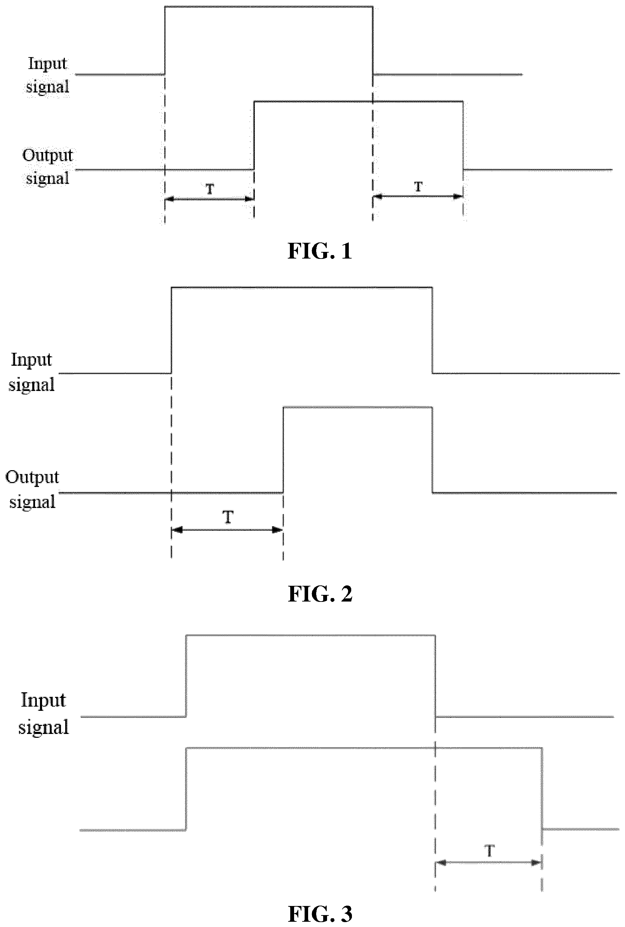

FIG. 1 is a schematic diagram of an input signal and an output signal obtained through a delay circuit. After the input signal passes through the delay circuit, a delay signal is output. As shown in FIG. 1, the output signal is a signal output after the input signal is delayed by time T. FIG. 1 shows a case where both a rising edge and a falling edge of the input signal are delayed by the time T. There is also a case where only the rising edge of the input signal is delayed by the time T or only the falling edge of the input signal is delayed by the time T.

In the existing delay circuit, the delay time T will significantly change (being longer or shorter) along with changes of the power supply voltage, operating temperature, and the manufacturing process, which will affect accuracy of the delay time. How to reduce influences of the change of the above parameters on the delay time T of the delay circuit so as to make less change of the delay time T is a problem urgent to be solved.

US 2011/102043 A1 discloses a system for compensating for power-supply-induced jitter (PSIJ) in a chain of clock buffers within an integrated circuit.

### SUMMARY

This application provides a control circuit and a delay circuit, for reducing influences of manufacturing process, power supply voltage, and working temperature of the delay circuit on delay time T of the delay circuit so as to make less change of the delay time T.

The present invention is defined in independent claims 1 and 8.

In the control circuit and the delay circuit provided in this application, the control unit, the first feedback unit, and the second feedback unit are arranged. The first terminal of the first feedback unit is connected to the first terminal of the control unit. The second terminal of the first feedback unit serves as an input terminal of the first reference voltage. The output terminal of the first feedback unit is connected to the second terminal of the control unit and the first terminal of the second feedback unit. The second terminal of the second feedback unit serves as an input terminal of the second reference voltage. The output terminal of the second feedback unit is connected to the third terminal of the control unit. The first feedback unit is configured to output the first feedback signal according to a voltage of the control unit and a first reference voltage. The second feedback unit is configured to output the second feedback signal according to an output voltage of the first feedback unit and a second reference voltage. The control unit is configured to adjust a voltage of a second terminal of the control unit according to the first feedback unit and adjust a voltage of a third terminal of the control unit according to the second feedback signal, so as to make a change value, changing along with a first parameter, of a current of the control unit be within a first range, the first parameter refers to any of the power supply voltage, working temperature, and manufacturing process, so that the second terminal and the third terminal of the control unit can respectively output a voltage that changes along with a change of any of the power supply voltage, working temperature, and manufacturing process.

### BRIEF DESCRIPTION OF THE DRAWINGS

FIG. 1 is a schematic diagram of an input signal and an output signal obtained through a delay circuit.
FIG. 2 is a schematic diagram of an input signal and an output signal obtained through a delay circuit.
FIG. 3 is a schematic diagram of an input signal and an output signal obtained through a delay circuit.
FIG. 4 is a schematic structural diagram of a potential generation circuit according to an embodiment representing parts of the invention.
FIG. 5 is a schematic structural diagram of a potential generation circuit according to an embodiment representing parts of the invention.
FIG. 6 is a schematic structural diagram of a potential generation circuit according to an embodiment of this application.
FIG. 7 is a schematic structural diagram of a potential generation circuit according to an embodiment of this application.
FIG. 8 is a schematic structural diagram of a potential generation circuit according to an embodiment of this application.
FIG. 9 is a schematic structural diagram of a potential generation circuit according to an embodiment of this application.
FIG. 10 is a schematic structural diagram of a potential generation circuit according to an embodiment of this application.
FIG. 11 is a schematic structural diagram of a potential generation circuit according to an embodiment of this application.
FIG. 12 is a schematic structural diagram of a potential generation circuit according to an embodiment of this application.
FIG. 13 is a schematic structural diagram of a delay circuit according to an embodiment of this application.
FIG. 14 is a schematic structural diagram of a delay circuit according to an embodiment of this application.
FIG. 15 is a schematic structural diagram of a delay circuit according to an embodiment of this application.
FIG. 16 is a schematic structural diagram of an inverter according to an embodiment representing parts of the invention.
FIG. 17 is a schematic structural diagram of a delay circuit according to an embodiment representing parts of the invention.
FIG. 18 is a schematic structural diagram of a potential generation circuit according to an embodiment representing parts of the invention.
FIG. 19 is a schematic structural diagram of a potential generation circuit according to an embodiment not covered by the invention.
FIG. 20 is a schematic structural diagram of a potential generation circuit according to an embodiment not covered by the invention.
FIG. 21 is a schematic structural diagram of a potential generation circuit according to an embodiment not covered by the invention.
FIG. 22 is a schematic structural diagram of a potential generation circuit according to an embodiment not covered by the invention.
FIG. 23 is a schematic structural diagram of a potential generation circuit according to an embodiment not covered by the invention.
FIG. 24 is a schematic structural diagram of a potential generation circuit according to an embodiment not covered by the invention.
FIG. 25 is a schematic structural diagram of a potential generation circuit according to an embodiment not covered by the invention.
FIG. 26 is a schematic structural diagram of a potential generation circuit according to an embodiment not covered by the invention.
FIG. 27 is a schematic structural diagram of a potential generation circuit according to an embodiment not covered by the invention.
FIG. 28 is a schematic structural diagram of a delay circuit according to an embodiment not covered by the invention.
FIG. 29 is a schematic structural diagram of a delay circuit according to an embodiment not covered by the invention.
FIG. 30 is a schematic structural diagram of a delay circuit according to an embodiment not covered by the invention.
FIG. 31 is a schematic structural diagram of an inverter according to an embodiment not covered by the invention.
FIG. 32 is a schematic structural diagram of an inverter according to an embodiment not covered by the invention.
FIG. 33 is a schematic structural diagram of a delay circuit according to an embodiment not covered by the invention.
FIG. 34 is a schematic structural diagram of a delay circuit according to an embodiment not covered by the invention.
FIG. 35 is a schematic structural diagram of a control circuit according to an embodiment not covered by the invention.
FIG. 36 is a schematic structural diagram of a control circuit according to an embodiment not covered by the invention.
FIG. 37 is a schematic structural diagram of a control circuit according to an embodiment not covered by the invention.
FIG. 38 is a schematic structural diagram of a control circuit according to an embodiment not covered by the invention.
FIG. 39 is a schematic structural diagram of a control circuit according to an embodiment not covered by the invention.
FIG. 40 is a schematic structural diagram of a control circuit according to an embodiment not covered by the invention.
FIG. 41 is a schematic structural diagram of a control circuit according to an embodiment not covered by the invention.
FIG. 42 is a schematic structural diagram of a control circuit according to an embodiment not covered by the invention.
FIG. 43 is a schematic structural diagram of a control circuit according to an embodiment not covered by the invention.
FIG. 44 is a schematic structural diagram of a control circuit according to an embodiment not covered by the invention.
FIG. 45 is a schematic structural diagram of a control circuit according to an embodiment not covered by the invention.
FIG. 46 is a schematic structural diagram of a control circuit according to an embodiment not covered by the invention.
FIG. 47 is a schematic structural diagram of a control circuit according to an embodiment not covered by the invention.
FIG. 48 is a schematic structural diagram of a control circuit according to an embodiment not covered by the invention.
FIG. 49 is a schematic structural diagram of a control circuit according to an embodiment not covered by the invention.
FIG. 50 is a schematic structural diagram of a control circuit according to an embodiment not covered by the invention.
FIG. 51 is a schematic structural diagram of a control circuit according to an embodiment not covered by the invention.
FIG. 52 is a schematic structural diagram of a control circuit according to an embodiment not covered by the invention.
FIG. 53 is a schematic structural diagram of a control circuit according to an embodiment not covered by the invention.
FIG. 54 is a schematic structural diagram of a control circuit according to an embodiment not covered by the invention.

### DETAILED DESCRIPTION

In order to make the objectives, technical solutions, and advantages this application clearer, the technical solutions in this application will be clearly and completely described below in combination with the drawings in this application. It is apparent that the described embodiments are not all embodiments but part of embodiments of this application. All other embodiments obtained by those of ordinary skill in the art on the basis of the embodiments in this application without creative work shall fall within the scope of protection of this application.

First, a rising edge delay time and a falling edge delay time involved in this application will be explained to facilitate understanding.
1. The rising edge delay time: FIG. 1 is a schematic diagram of an input signal and an output signal obtained through a delay circuit. As shown in FIG. 1, delay time T between a rising edge of the output signal and a rising edge of the input signal is the rising edge delay time.
2. The falling edge delay time: As shown in FIG. 1, delay time T between a falling edge of the output signal and a falling edge of the input signal is the falling edge delay time.

Through a delay circuit provided in this application, both the rising edge and the falling edge of the input signal can be delayed by time T, with a pulse signal width unchanged. As shown in FIG. 1, the rising edge of the input signal can be delayed by time T, and the falling edge of the input signal can also be delayed by time T. FIG. 2 is a schematic diagram of an input signal and an output signal obtained through a delay circuit. As shown in FIG. 2, a rising edge of the input signal is delayed by time T to obtain the output signal, and a pulse signal width is shortened by time T. FIG. 3 is a schematic diagram of an input signal and an output signal obtained through a delay circuit. As shown in FIG. 3, a falling edge of the input signal is delayed by time T to obtain the output signal, and a pulse signal width is prolonged by time T. It is to be noted that FIG. 1 to FIG. 3 only show one cycle of a pulse signal.

The delay circuit provided in this application can be applied to scenarios requiring precise control on the delay time of the delay circuit. For example, the delay circuit can be applied to a Dynamic Random Access Memory (DRAM), and can simultaneously compensate for an influence of a change of any of power supply voltage, working temperature, and manufacturing process on the delay time, so that the delay time T may have less change, and control capability of the delay circuit to accuracy of the delay time is improved.

A delay unit of an existing delay circuit includes an inverter composed of two transistors (a P-type transistor and an N-type transistor). Delay time T of an output signal obtained through the delay circuit may greatly change along with changes of the power supply voltage, working temperature, and manufacturing process, which may affect accuracy of the delay time. This application solves the problem from the perspective of a structure of the delay unit. Since the changes of the power supply voltage, working temperature, and manufacturing process all may cause a current flowing through the two transistors of the inverter to change, the delay time may change. Thus, this application provides a delay circuit, including a potential generation circuit and a delay unit. The potential generation circuit includes a first transistor and a second transistor. A potential of a substrate terminal of the first transistor as well as a potential of a substrate terminal of the second transistor changes along with a change of a first parameter, and the first parameter refers to any of the power supply voltage, working temperature, and manufacturing process of the potential generation circuit. The delay unit includes a first inverter. The first inverter includes a fourth transistor and a fifth transistor. A substrate terminal of the fourth transistor is connected to the potential of the substrate terminal of the first transistor, and a substrate terminal of the fifth transistor is connected to the potential of the substrate terminal of the second transistor.

Since the potential of the first transistor may change along with the change of any of the power supply voltage, working temperature, and manufacturing process, a substrate potential that changes along with the change of the first parameter may be provided to the substrate terminal of the fourth transistor. Since the potential of the second transistor may change along with the change of any of the power supply voltage, working temperature, and manufacturing process, a substrate potential that changes along with the change of the first parameter may be provided to the substrate terminal of the fifth transistor. Thus, the current flowing through the two transistors of the first inverter may be adjusted, and a change value of the current flowing through the two transistors of the inverter may be compensated, so that the delay time T of the delay circuit may have less change, and control capability of the delay circuit to accuracy of the delay time is improved.

Specific structures of the control circuit and the delay circuit provided in this application will be described in detail below through specific embodiments.

### Embodiment 1

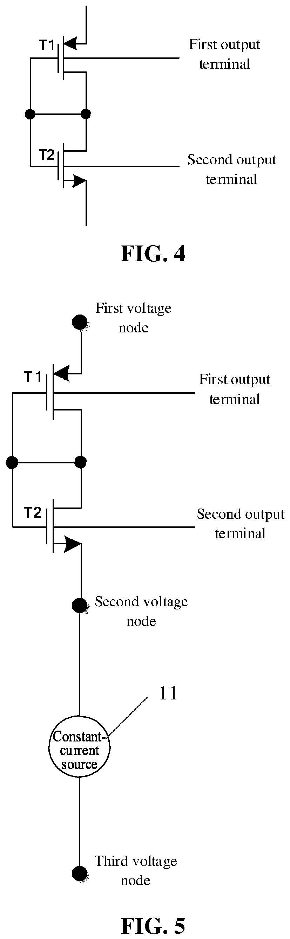

FIG. 4 is a schematic structural diagram of a potential generation circuit according to an embodiment representing parts of the invention. As shown in FIG. 4, the potential generation circuit according to the embodiment may include a first transistor T1 and a second transistor T2. A potential of a substrate terminal of the first transistor T1 changes along with a change of a first parameter; the first parameter refers to any of power supply voltage, working temperature, and manufacturing process of the potential generation circuit; and a potential of a substrate terminal of the second transistor T2 changes along with the change of the first parameter.

A gate terminal of the first transistor T1 is connected to a drain terminal thereof. The substrate terminal of the first transistor T1 serves as a first output terminal of the potential generation circuit. A gate terminal of the second transistor T2 is connected to a drain terminal thereof. The substrate terminal of the second transistor T2 serves as a second output terminal of the potential generation circuit.

Specifically, the potential of the substrate terminal of the first transistor T1 is a potential output from the first output terminal, and the potential of the substrate terminal of the second transistor T2 is a potential output from the second output terminal. The potential of the substrate terminal of the first transistor T1 as well as the potential of the substrate terminal of the second transistor T2 changes along with the change of the first parameter, and thus, the potential generation circuit according to the embodiment can output a potential that changes along with the change of any of the power supply voltage, working temperature, and manufacturing process.

Specifically, if the first parameter refers to the power supply voltage or working temperature of the potential generation circuit, the potential of the substrate terminal of the first transistor T1 as well as the potential of the substrate terminal of the second transistor T2 changes along with the change of the first parameter, which may specifically include: the potential of the substrate terminal of the first transistor T1 rises along with an increase of the first parameter and falls along with a decrease of the first parameter, that is, the potential and the first parameter are directly proportional; the potential of the substrate terminal of the second transistor T2 falls along with an increase of the first parameter and rises along with a decrease of the first parameter.

In an implementation mode, the first transistor T1 is a P-type transistor, and the second transistor T2 is an N-type transistor.

In an implementation mode, a source terminal of the first transistor T1 is connected to a first voltage node, a source terminal of the second transistor T2 is connected to a second voltage node, and a drain terminal of the first transistor T1 is connected to a drain terminal of the second transistor T2.

In this implementation mode, FIG. 5 is a schematic structural diagram of a potential generation circuit according to an embodiment representing parts of the invention. As shown in FIG. 5, based on the circuit shown in FIG. 4, the potential generation circuit according to the embodiment further includes a constant-current source 11, a first terminal of the constant-current source 11 is connected to the second voltage node, and a second terminal of the constant-current source 11 is connected to a third voltage node.

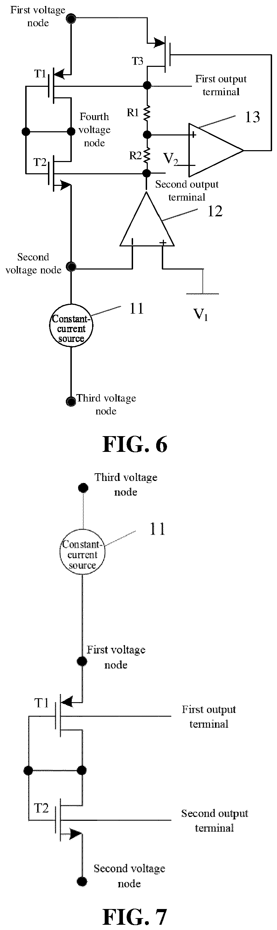

FIG. 6 is a schematic structural diagram of a potential generation circuit according to an embodiment of this application. As shown in FIG. 6, based on the circuit shown in FIG. 5, the potential generation circuit according to the embodiment may further include a first error amplifier 12, a second error amplifier 13, and a third transistor T3.

The first error amplifier 12 and the second transistor T2 form a first feedback loop, and a substrate terminal of the second transistor T2 is connected to a voltage node of the first feedback loop.

The second error amplifier 13 and the third transistor T3 form a second feedback loop, and the substrate terminal of the first transistor is connected to a voltage node of the second feedback loop.

As shown in FIG. 6, a negative input terminal of the first error amplifier 12 is connected to the second voltage node, a positive input terminal of the first error amplifier 12 is connected to a first reference voltage V₁, and an output terminal of the first error amplifier 12 is connected to the substrate terminal of the second transistor T2.

A negative input terminal of the second error amplifier 13 is connected to a second reference voltage V₂. A positive input terminal of the second error amplifier 13 is connected to a fourth voltage node. An output terminal of the second error amplifier 13 is connected to a gate terminal of the third transistor T3. A source terminal of the third transistor T3 is connected to the first voltage node. A drain terminal of the third transistor T3 is coupled to a fourth voltage node through a first resistor R1. An output terminal of the first error amplifier 12 is coupled to the fourth voltage node through a second resistor R2.

In the embodiment, the first voltage node may be connected to a power supply end, the first reference voltage Vi may be connected to ground, and a potential of the third voltage node is less than that of the first reference voltage V₁.

In the potential generation circuit shown in FIG. 6, the first voltage node is connected to the power supply end, the first reference voltage Vi is connected to the ground, and the potential of the third voltage node is less than that of V₁, that is, the potential of the third voltage node is less than 0. The potential of the first voltage node is greater than that of the third voltage node.

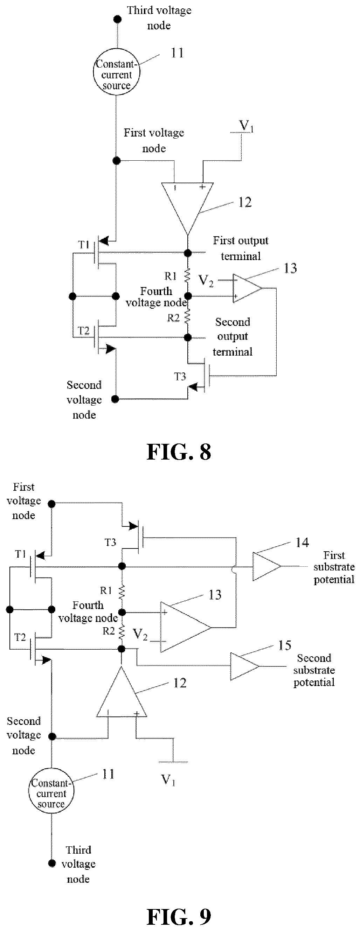

Another potential generation circuit is shown below with reference to FIG. 7 and FIG. 8, which will be described in detail below in conjunction with FIG. 7 and FIG. 8.

FIG. 7 is a schematic structural diagram of a potential generation circuit according to an embodiment of this application. As shown in FIG. 7, based on the circuit shown in FIG. 4, the potential generation circuit according to the embodiment further includes a constant-current source 11, a first terminal of the constant-current source 11 is connected to a third voltage node, and a second terminal of the constant-current source 11 is connected to a first voltage node.

FIG. 8 is a schematic structural diagram of a potential generation circuit according to an embodiment of this application. As shown in FIG. 8, based on the circuit shown in FIG. 7, the potential generation circuit according to the embodiment may further include a first error amplifier 12 which forms a first feedback loop with the first transistor T1. The substrate terminal of the first transistor T1 is connected to a voltage node of the first feedback loop.

In addition, a second error amplifier 13 and a third transistor T3 are also included. The second error amplifier 13 and the third transistor T3 form a second feedback loop, and the substrate terminal of the second transistor T2 is connected to a voltage node of the second feedback loop.

As shown in FIG. 8, a negative input terminal of the first error amplifier 12 is connected to a first voltage node, a positive input terminal of the first error amplifier is connected to a first reference voltage Vi, and an output terminal of the first error amplifier 12 is connected to the substrate terminal of the first transistor T1.

A negative input terminal of the second error amplifier 13 is connected to a second reference voltage V₂. A positive input terminal of the second error amplifier 13 is connected to a fourth voltage node. An output terminal of the second error amplifier 13 is connected to a gate terminal of the third transistor T3. A source terminal of the third transistor T3 is connected to a second voltage node. A drain terminal of the third transistor T3 is coupled to the fourth voltage node through a second resistor R2. An output terminal of the first error amplifier 12 is coupled to the fourth voltage node through a first resistor R1.

In the embodiment, the second voltage node may be connected to ground, the first reference voltage V₁ may be connected to a power supply end, and a potential of the third voltage node is greater than that of the first reference voltage Vi.

In the potential generation circuit shown in FIG. 8, the second voltage node is connected to the ground, the first reference voltage V₁ is connected to the power supply end, and the potential of the third voltage node is greater than that of V₁, that is, the potential of the third voltage node is greater than a potential of the power supply end. The potential of the first voltage node is less than that of the third voltage node.

The potential generation circuit shown in any of FIG. 4 to FIG. 8 is provided with the first transistor and the second transistor. The gate terminal of the first transistor is connected to the drain terminal thereof. The substrate terminal of the first transistor serves as the first output terminal of the potential generation circuit. The gate terminal of the second transistor is connected to the drain terminal thereof. The substrate terminal of the second transistor serves as the second output terminal of the potential generation circuit. Since the potential of the substrate terminal of the first transistor as well as the potential of the substrate terminal of the second transistor changes along with the change of the first parameter, the first output terminal and the second output terminal can respectively output a potential that changes along with the change of any of the power supply voltage, working temperature, and manufacturing process.

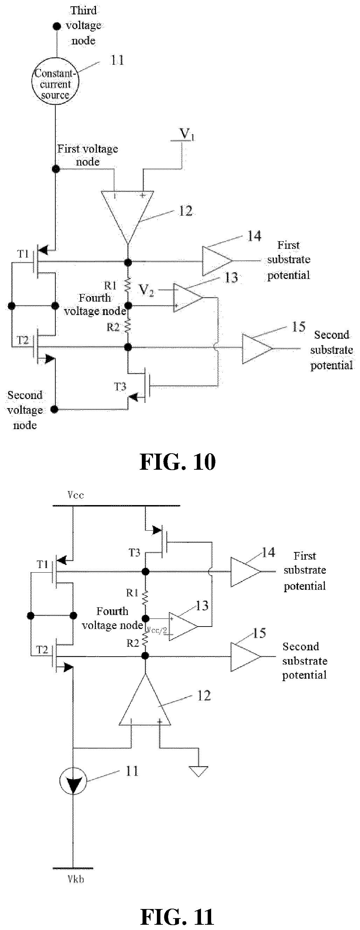

Further, based on the potential generation circuit as shown in any of FIG. 4 to FIG. 8, a first buffer 14 and a second buffer 15 may also be included. FIG. 9 is a schematic structural diagram of a potential generation circuit according to an embodiment of this application. FIG. 10 is a schematic structural diagram of a potential generation circuit according to an embodiment of this application. Based on the circuit shown in FIG. 6, the potential generation circuit shown in FIG. 9 may further include a first buffer 14 and a second buffer 15. Based on the circuit shown in FIG. 8, the potential generation circuit shown in FIG. 10 may further include a first buffer 14 and a second buffer 15.

Referring to FIG. 9 and FIG. 10, the first buffer 14 is connected to the first output terminal and outputs a first substrate potential. A value of the first substrate potential is equal to a potential value of the substrate terminal of the first transistor T1. An input potential of the first buffer 14 is equal to an output potential thereof. The first buffer 14 is configured to improve drive capability of the potential of the substrate terminal of the first transistor T1, and can also isolate the substrate terminal of the first transistor T1 to prevent the potential of the substrate terminal of the first transistor T1 from being interfered.

The second buffer 15 is connected to the second output terminal and outputs a second substrate potential. A value of the second substrate potential is equal to a potential value of the substrate terminal of the second transistor T2. An input potential of the second buffer 15 is equal to an output potential thereof. The second buffer 15 is configured to improve drive capability of the potential of the substrate terminal of the second transistor T2, and can also isolate the substrate terminal of the second transistor T2 to prevent the potential of the substrate terminal of the second transistor T2 from being interfered.

The structure of the potential generation circuit of this application will be described below in conjunction with specific embodiments. The specific structure of the potential generation circuit of this application is not limited to any of the following structures.

FIG. 11 is a schematic structural diagram of a potential generation circuit according to an embodiment of this application. The potential generation circuit according to the embodiment may include a first transistor T1, a second transistor T2, a constant-current source 11, a first error amplifier 12, a second error amplifier 13, a first resistor R1, a second resistor R2, a third transistor T3, a first buffer 14, and a second buffer 15.

In this embodiment, the first transistor T1 is a P-type transistor, and the second transistor T2 is an N-type transistor. A gate terminal of the first transistor T1 is connected to a drain terminal thereof. A gate terminal of the second transistor T2 is connected to a drain terminal thereof. A source terminal of the first transistor T1 is connected to a power supply end Vcc. A source terminal of the second transistor T2 is connected to a first terminal of the constant-current source 11. The drain terminal of the first transistor T1 is connected to the drain terminal of the second transistor T2. A second terminal of the constant-current source 11 is connected to Vkb of which a potential is less than 0.

The first error amplifier 12 and the second transistor T2 form a first feedback loop. A negative input terminal of the first error amplifier 12 is connected to the source terminal of the second transistor T2 and the first terminal of the constant-current source 11. A positive input terminal of the first error amplifier 12 is connected to ground. An output terminal of the first error amplifier 12 is connected to a substrate terminal of the second transistor T2.

A negative input terminal of the second error amplifier 13 is connected to a power supply end which may be, for example, Vcc/2. A positive input terminal of the second error amplifier 13 is connected to a fourth voltage node. An output terminal of the second error amplifier 13 is connected to a gate terminal of the third transistor T3. A source terminal of the third transistor T3 is connected to the power supply end Vcc. A drain terminal of the third transistor T3 is coupled to a fourth voltage node through the first resistor R1. The output terminal of the first error amplifier 12 is coupled to the fourth voltage node through the second resistor R2.

The first buffer 14 is connected to a substrate terminal of the first transistor and outputs a first substrate potential. A value of the first substrate potential is equal to a potential value of the substrate terminal of the first transistor T1. The second buffer 15 is connected to a substrate terminal of the second transistor and outputs a second substrate potential. A value of the second substrate potential is equal to a potential value of the substrate terminal of the second transistor T2.

Optionally, the first resistor R1 and the second resistor R2 may be set with large resistance values, for example, 100MΩ. Since the resistance values of the first resistor R1 and the second resistor R2 are set to be large, output of the first error amplifier 12 may slowly affect input of the second error amplifier 13 only and have a small influence to the first substrate potential.

In this embodiment, the potential of the substrate terminal of the first transistor T1 rises along with an increase of a first parameter, and the potential of the substrate terminal of the first transistor T1 falls along with a decrease of the first parameter. The potential of the substrate terminal of the second transistor T2 falls along with an increase of the first parameter, and rises along with a decrease of the first parameter. The first parameter refers to any of the power supply voltage, working temperature and manufacturing process of the potential generation circuit.

Taking the first parameter referring to the working temperature as an example, the principle that the potential of the substrate terminal of the first transistor T1 changes with the change of the first parameter, and the principle that the potential of the substrate terminal of the second transistor T2 changes along with the change of the first parameter will be described in detail below.

A current flowing through the first transistor T1 is Id=µ*Cox*(W/L)*(Vgs-Vth)², where µ is an electronic mobility, Cox is a gate capacitance, Vgs is a voltage difference between a gate and a source, and Vth is a threshold voltage. For example, with rise of the working temperature, the electronic mobility µ decreases, which may decrease the current Id flowing through the first transistor T1, and prolong delay time of a corresponding inverter. Here, if Vgs-Vth is adjusted to be greater, a current change caused by a decrease of the electronic mobility µ may be compensated. The specific adjusted value may be set according to actual requirements. In the potential generation circuit shown in FIG. 11, if temperature rises, the electronic mobility µ decreases, and the current Id flowing through the first transistor T1 decreases. In order to keep the current of the constant-current source constant, the first substrate potential needs to be increased, for example, to be Vcc+100mV, while the second substrate potential needs to be decreased, for example, to be -100mV When temperature rises, the current Id flowing through the first transistor T1 and the second transistor T2 decreases. For the constant-current source 11, the current provided from the upper side decreases, while the current flowing to the lower side does not change, so that the potential of the negative input terminal of the first error amplifier 12 decreases and the second substrate potential decreases, which may cause the output of the first error amplifier 12 to gradually become -100mV. Then, the potential of the positive input terminal of the second error amplifier 13 decreases, resulting in a decrease of an output voltage of the second error amplifier 13 and an improvement of pull-up capability of the third transistor T3, so that the voltage of the first substrate potential rises, and the first substrate potential gradually becomes Vcc+100mV.

When the first parameter refers to the power supply voltage and the manufacturing process, changes of the power supply voltage and the manufacturing process may cause a change of the current Id flowing through the first transistor T1, thereby resulting in a change of the delay time. The principle of compensation is similar to the foregoing principle, which will not be elaborated here.

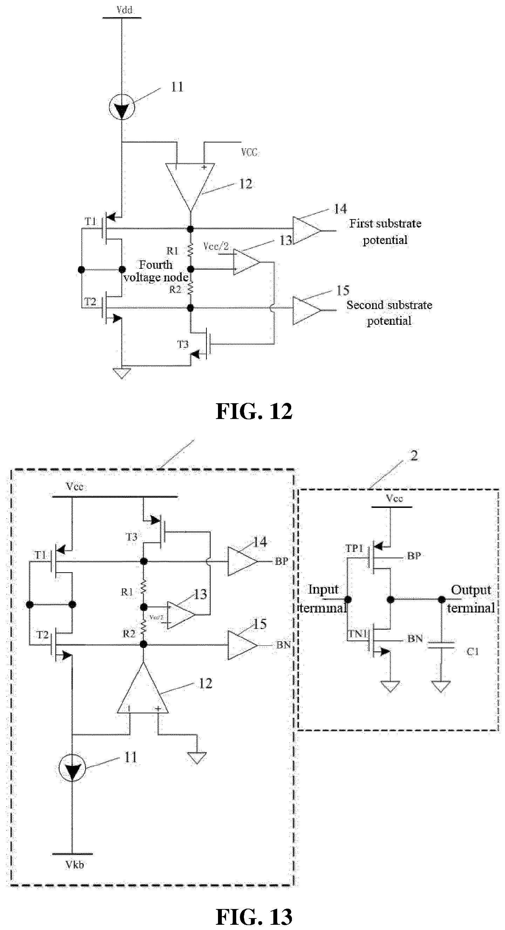

FIG. 12 is a schematic structural diagram of a potential generation circuit according to an embodiment of this application. The potential generation circuit according to the embodiment may include a first transistor T1, a second transistor T2, a constant-current source 11, a first error amplifier 12, a second error amplifier 13, a first resistor R1, a second resistor R2, a third transistor T3, a first buffer 14, and a second buffer 15.

In this embodiment, the first transistor T1 is a P-type transistor, and the second transistor T2 is an N-type transistor. A gate terminal of the first transistor T1 is connected to a drain terminal thereof. A gate terminal of the second transistor T2 is connected to a drain terminal thereof. A source terminal of the first transistor T1 is connected to a first terminal of the constant-current source 11. A source terminal of the second transistor T2 is connected to ground. The drain terminal of the first transistor T1 is connected to the drain terminal of the second transistor T2. A second terminal of the constant-current source 11 is connected to a power supply end Vdd.

The first error amplifier 12 and the first transistor T1 form a first feedback loop. A negative input terminal of the first error amplifier 12 is connected to the first terminal of the constant-current source 11. A positive input terminal of the first error amplifier is connected to a power supply end Vcc. An output terminal of the first error amplifier 12 is connected to a substrate terminal of the first transistor T1.

Vdd is greater than Vcc.

A negative input terminal of the second error amplifier 13 is connected to a power supply end which may be, for example, Vcc/2. A positive input terminal of the second error amplifier 13 is connected to a fourth voltage node. An output terminal of the second error amplifier 13 is connected to a gate terminal of the third transistor T3. A source terminal of the third transistor T3 is connected to the ground. A drain terminal of the third transistor T3 is coupled to a fourth voltage node through the second resistor R2. The output terminal of the first error amplifier 12 is coupled to the fourth voltage node through the first resistor R1.

The first buffer 14 is connected to a substrate terminal of the first transistor and outputs a first substrate potential. A value of the first substrate potential is equal to a potential value of the substrate terminal of the first transistor T1. The second buffer 15 is connected to a substrate terminal of the second transistor and outputs a second substrate potential. A value of the second substrate potential is equal to a potential value of the substrate terminal of the second transistor T2.

In this embodiment, the potential of the substrate terminal of the first transistor T1 rises along with an increase of a first parameter, and the potential of the substrate terminal of the first transistor T1 falls along with a decrease of the first parameter. The potential of the substrate terminal of the second transistor T2 falls along with an increase of the first parameter, and rises along with a decrease of the first parameter. The first parameter refers to any of the power supply voltage, working temperature, and manufacturing process of the potential generation circuit.

Taking the first parameter referring to the working temperature as an example, the principle that the potential of the substrate terminal of the first transistor T1 changes with the change of the first parameter, and the principle that the potential of the substrate terminal of the second transistor T2 changes along with the change of the first parameter will be described in detail below.

A current flowing through the first transistor T1 is Id=µ*Cox*(W/L)*(Vgs-Vth)², where µ is an electronic mobility, and Vth is a threshold voltage. For example, with rise of the working temperature, the electronic mobility µ decreases, which may decrease the current Id flowing through the first transistor T1, and prolong delay time of a corresponding inverter. Here, if Vgs-Vth is adjusted to be greater, a current change caused by a decrease of the electronic mobility µ may be compensated. The specific adjusted value may be set according to actual requirements. In the potential generation circuit shown in FIG. 12, if temperature rises, the electronic mobility µ decreases, and the current Id flowing through the first transistor T1 decreases. In order to keep the current of the constant-current source constant, the second substrate potential needs to be decreased, for example, to be -100mV, while the first substrate potential needs to be increased, for example, to be Vcc+100mV. If temperature rises, the current provided from the upper side of the constant-current source does not change, the current, flowing to the lower side, of the constant-current source is equal to the current Id flowing through the first transistor T1 and the second transistor T2. Id decreases, so that the potential of the negative input terminal of the first error amplifier 12 is increased, and the first substrate potential is increased, which may cause the output of the first error amplifier 12 to gradually become Vcc+100mV. Then, there is an increase at the positive input terminal of the second error amplifier 13, which results in an increase of an output voltage of the second error amplifier 13 and an improvement of pull-up capability of the third transistor T3, so that the voltage of the second substrate potential decreases.

When the first parameter refers to the power supply voltage and the manufacturing process, changes of the power supply voltage and the manufacturing process may cause a change of the current Id flowing through the first transistor T1, thereby resulting in a change of the delay time. The principle of compensation is similar to the foregoing principle, which will not be elaborated here.

The embodiment of this application further provides a delay circuit, including the potential generation circuit shown in any of FIG. 4 to FIG. 12 and a delay unit. The delay unit includes a first inverter. The first inverter includes a fourth transistor and a fifth transistor. A substrate terminal of the fourth transistor is connected to the potential of the substrate terminal of the first transistor T1, and a substrate terminal of the fifth transistor is connected to the potential of the substrate terminal of the second transistor T2.

In the delay circuit provided in the embodiment, since the potential of the first transistor in the potential generation circuit may change along with the change of any of the power supply voltage, working temperature, and manufacturing process, a substrate potential that changes along with the change of the first parameter may be provided to the substrate terminal of the fourth transistor. Since the potential of the second transistor may change along with the change of any of the power supply voltage, working temperature, and manufacturing process, a substrate potential that changes along with the change of the first parameter may be provided to the substrate terminal of the fifth transistor. Thus, the current flowing through the two transistors of the first inverter may be adjusted, and a change value of the current flowing through the two transistors of the inverter may be compensated, so that delay time T of the delay circuit may have less change, and control capability of the delay circuit to accuracy of the delay time is improved.

When the first transistor is a P-type transistor, the second transistor is an N-type transistor, the fourth transistor is a P-type transistor, and the fifth transistor is an N-type transistor, since the first substrate potential that changes along with the change of the first parameter is provided to the substrate terminal of the P-type transistor, a change value of a rising edge delay time of the delay circuit may be adjusted, and the change of the rising edge delay time of the delay circuit may be minor; since the second substrate potential that changes along with the change of the first parameter is provided to the substrate terminal of the N-type transistor, a change value of a falling edge delay time of the delay circuit may be adjusted, and the change of the falling edge delay time of the delay circuit may be minor.

It is to be noted that, in the embodiment of this application, connection relationships between the potential generation circuit and the inverters may be set according to the number of the inverters included in the delay circuit and the requirements for compensation of the delay time. For example, two inverters are in series connection, a substrate terminal of a P-type transistor of each inverter is connected to a substrate terminal of a P-type transistor of the potential generation circuit, so that the change value of the rising edge delay time of the delay circuit may be adjusted; a substrate terminal of an N-type transistor of the inverter is connected to a substrate terminal of an N-type transistor of the potential generation circuit, so that the change value of the falling edge delay time of the delay circuit may be adjusted. Specifically, the connection relationships between the potential generation circuit and the inverters may be set according to the change value of the rising edge and/or falling edge delay time required to be adjusted. The potential generation circuit provided in the embodiment of this application may be applied to a delay circuit requiring both a rising edge delay and/or a falling edge delay, and can reduce influences of changes of the manufacturing process, power supply voltage, and working temperature of the delay circuit on delay time T of the delay circuit, so that the delay time T (including the rising edge delay time and/or the falling edge delay time) may have less change, and control capability of the delay circuit to accuracy of the delay time is improved.

Three examples of the delay circuit are given below with reference to FIG. 13 to FIG. 15. FIG. 13 is a schematic structural diagram of a delay circuit according to an embodiment of this application. As shown in FIG. 13, the delay circuit according to the embodiment includes a potential generation circuit 1 and a delay unit 2. The potential generation circuit 1 is the circuit shown in FIG. 11, its specific structure description may refer to the description in the embodiment shown in FIG. 11, which will not be elaborated here. The potential generation circuit 1 outputs a first substrate potential BP and a second substrate potential BN. The delay unit 2 includes an inverter and a capacitor C1. The inverter includes a P-type transistor TP1 and an N-type transistor TN1. A substrate terminal of the P-type transistor TP1 is connected to the first substrate potential BP, and a substrate terminal of the N-type transistor TN1 is connected to the second substrate potential BN. In the delay circuit according to the embodiment, the potential generation circuit 1 provides the first substrate potential that changes along with a change of a first parameter to the substrate terminal of the P-type transistor in the delay unit 2. When an input terminal of the delay unit 2 refers to a falling edge, the first substrate potential BP may adjust a change value of a rising edge delay time of the delay circuit, so that the rising edge delay time of the delay circuit may have less change. The potential generation circuit 1 provides the second substrate potential that changes along with changes of the first parameter to the substrate terminal of the N-type transistor in the delay unit 2. When the input terminal of the delay unit 2 refers to a rising edge, the second substrate potential BN may adjust a change value of a falling edge delay time of the delay circuit, so that the falling edge delay time of the delay circuit may have less change; thus, influences of the manufacturing process, power supply voltage, and working temperature of the delay circuit to the delay time T may be reduced, the change of the delay time T (including the rising edge delay time and the falling edge delay time) is less, and control capability of the delay circuit to accuracy of the delay time is improved.

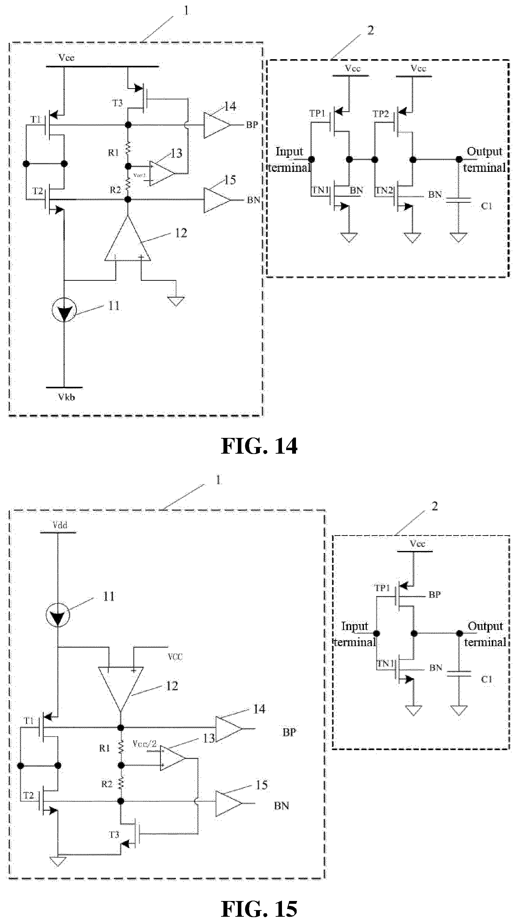

FIG. 14 is a schematic structural diagram of a delay circuit according to an embodiment of this application. As shown in FIG. 14, the delay circuit according to the embodiment includes a potential generation circuit 1 and a delay unit 2. The potential generation circuit 1 is the circuit shown in FIG. 11, its specific structure description may refer to the description in the embodiment shown in FIG. 11, which will not be elaborated here. The potential generation circuit 1 outputs a first substrate potential BP and a second substrate potential BN. The delay unit 2 includes a first inverter, a second inverter, and a capacitor C1. The first inverter includes a P-type transistor TP1 and an N-type transistor TN1. The second inverter includes a P-type transistor TP2 and an N-type transistor TN2. In the delay unit 2, a substrate terminal of the N-type transistor TN1 is connected to the second substrate potential BN, and a substrate terminal of the N-type transistor TN2 is connected to the second substrate potential BN. In the delay circuit according to the embodiment, the potential generation circuit 1 provides the second substrate potential BN that changes along with the change of a first parameter to the substrate terminals of the N-type transistor TN1 and the N-type transistor TN2 in the delay unit 2. When an input terminal of the delay unit 2 refers to a rising edge, a change value of a falling edge delay time of the delay circuit may be adjusted, so that the falling edge delay time of the delay circuit may have less change; thus, influences of the manufacturing process, power supply voltage, and working temperature of the delay circuit to the rising edge delay time T of the delay circuit may be reduced, the change of the rising edge delay time T is less, and control capability of the delay circuit to accuracy of the delay time is improved.

It is to be understood that in another delay circuit, in the delay unit 2, a substrate terminal of the P-type transistor TP1 is connected to the first substrate potential BP, and a substrate terminal of the P-type transistor TP2 is connected to the first substrate potential BP, so that the change value of the falling edge delay time of the delay circuit may be adjusted and the falling edge delay time of the delay circuit may have less change.

FIG. 15 is a schematic structural diagram of a delay circuit according to an embodiment of this application. As shown in FIG. 15, the difference of the delay circuit in the embodiment over the delay circuit shown in FIG. 13 lies in: the potential generation circuit 1 in the embodiment is the circuit shown in FIG. 12. Other structures are the same, and the effects achieved are also the same, which will not be elaborated here.

The embodiment of this application further provides a delay circuit, including the potential generation circuit shown in any of FIG. 9 to FIG. 12 and a delay unit. The delay unit includes a first inverter. The first inverter includes a fourth transistor and a fifth transistor. A substrate terminal of the fourth transistor is connected to a first substrate potential, and a substrate terminal of the fifth transistor is connected to a second substrate potential.

In the delay circuit provided in the embodiment, since the first substrate potential in the potential generation circuit may change along with the change of any of the power supply voltage, working temperature, and manufacturing process, the first substrate potential that changes along with a change of a first parameter may be provided to the substrate terminal of the fourth transistor. Since the second potential of the second transistor may change along with the change of any of the power supply voltage, working temperature, and manufacturing process, the second substrate potential that changes along with the change of the first parameter may be provided to the substrate terminal of the fifth transistor. Thus, the current flowing through the two transistors of the first inverter may be adjusted, and a change value of the current flowing through the two transistors of the inverter may be compensated, so that delay time T of the delay circuit may have less change, and control capability of the delay circuit to accuracy of the delay time is improved.

In the foregoing two delay circuits, a ratio of a channel length of the first transistor T1 to a channel length of the fourth transistor is denoted as H, a ratio of a channel length of the second transistor T2 to a channel length of the fifth transistor is denoted as L, a ratio of a channel width of the first transistor T1 to a channel width of the fourth transistor is denoted as M, and a ratio of a channel width of the second transistor T2 to a channel width of the fifth transistor is denoted as N, where H is equal to L, M is equal to N, and optionally, H, L, M, and N may be 1. Optionally, the first transistor and the fourth transistor may be of the same type, and the second transistor and the fifth transistor may be of the same type.

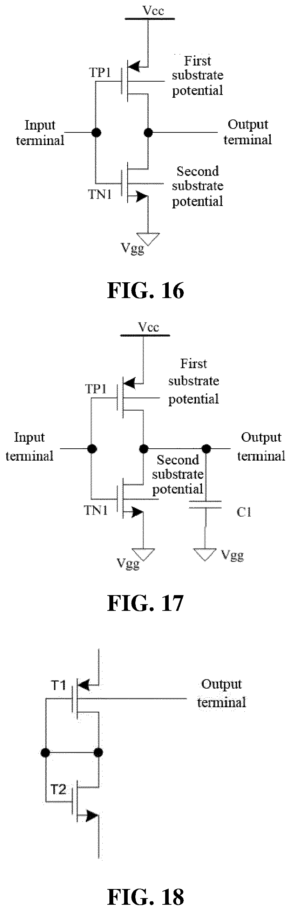

The embodiment of this application further provides an inverter. FIG. 16 is a schematic structural diagram of an inverter according to an embodiment representing parts of the invention. As shown in FIG. 16, the inverter includes a P-type transistor TP1 and an N-type transistor TN1.

A source terminal of the P-type transistor TP1 is connected to a power supply end. A drain terminal of the P-type transistor TP1 is connected to a drain terminal of the N-type transistor TN1. A source terminal of the N-type transistor TN1 is connected to ground. A gate terminal of the P-type transistor TP1 is connected to a gate terminal of the N-type transistor TN1 and serves as an input terminal of the inverter. The drain terminal of the P-type transistor serves as an output terminal of the inverter.

A substrate terminal of the P-type transistor TP1 is connected to a first substrate potential. A substrate terminal of the N-type transistor TN1 is connected to a second substrate potential. The first substrate potential as well as the second substrate potential changes along with a change of a first parameter. The first parameter refers to any of the power supply voltage, working temperature, and manufacturing process of the inverter.

When the first parameter refers to the power supply voltage or working temperature of the inverter, the first substrate potential rises along with an increase of the first parameter and decreases along with a decrease of the first parameter; the second substrate potential falls along with an increase of the first parameter and rises along with a decrease of the first parameter.

In the inverter provided in the embodiment, since the first substrate potential may change along with the change of any of the power supply voltage, working temperature, and manufacturing process, the first substrate potential that changes along with the change of the first parameter may be provided to the substrate terminal of TP1. Since the second substrate potential may change along with the change of any of the power supply voltage, working temperature, and manufacturing process, the second substrate potential that changes along with the change of the first parameter may be provided to the substrate terminal of TN1. Thus, a current flowing through the P-type transistor and the N-type transistor of the inverter may be adjusted, and a change value of the current flowing through the two transistors of the inverter may be compensated, so that delay time T of the delay circuit may have less change, and control capability of the delay circuit to accuracy of the delay time is improved.

The embodiment of this application further provides a delay circuit. FIG. 17 is a schematic structural diagram of a delay circuit according to an embodiment representing parts of the invention. As shown in FIG. 17, the delay circuit according to the embodiment may include the inverter shown in FIG. 16 and a capacitor C1. One terminal of the capacitor C1 is connected to the ground. In an implementation mode, the capacitor C1 may be a capacitor array.

The delay circuit provided in the embodiment may compensate the change value of the current flowing through the two transistors of the inverter, so that the delay time T of the inverter may have less change, further the delay time T of the delay circuit may have less change, and control capacitor of the delay circuit to accuracy of the delay time is improved.

The embodiment of this application further provides a logic gate circuit, including a P-type transistor and an N-type transistor. A substrate terminal of the P-type transistor is connected to a first substrate potential. A substrate terminal of the N-type transistor is connected to a second substrate potential. The first substrate potential as well as the second substrate potential changes along with a change of a first parameter, so that the change value, changing along with the change of the first parameter, of delay time, from an input terminal to an output terminal, of the logic gate circuit is within a first range. The first parameter refers to any of the power supply voltage, working temperature, and manufacturing process of the of the logic gate circuit.

Specifically, the first range is a small range, for example, a range close to 0. For example, the first range is 1% or 3% or 5%, so that the delay time, from the input terminal to the output terminal, of the logic gate circuit may have less change during changing of any of the power supply voltage, operating temperature, and manufacturing process, and control capability of the logic gate circuit to accuracy of the delay time is improved.

### Embodiment 2

FIG. 18 is a schematic structural diagram of a potential generation circuit according to an embodiment representing parts of the invention. As shown in FIG. 18, the potential generation circuit according to the embodiment may include a first transistor T1 and a second transistor T2. A potential of a substrate terminal of the first transistor T1 changes along with a change of a first parameter. The first parameter refers to any of power supply voltage, working temperature, and manufacturing process of the potential generation circuit.

A gate terminal of the first transistor T1 is connected to a drain terminal thereof. The substrate terminal of the first transistor T1 serves as an output terminal of the potential generation circuit. A gate terminal of the second transistor T2 is connected to a drain terminal thereof.

Specifically, the potential of the substrate terminal of the first transistor T1 is a potential output from the output terminal. The potential of the substrate terminal of the first transistor T1 changes along with the change of the first parameter, and thus, the potential generation circuit provided in the embodiment can output a potential that changes along with the change of any of the power supply voltage, working temperature, and manufacturing process.

Specifically, if the first parameter refers to the power supply voltage or working temperature of the potential generation circuit, the potential of the substrate terminal of the first transistor T1 changes along with the change of the first parameter, which may specifically include: the potential of the substrate terminal of the first transistor T1 rises along with an increase of the first parameter and decreases along with a decrease of the first parameter, that is, the potential and the first parameter are directly proportional.

In an implementation mode, the first transistor T1 is a P-type transistor, and the second transistor T2 is an N-type transistor.

In an implementation mode, a source terminal of the first transistor T1 is connected to a first voltage node, a source terminal of the second transistor T2 is connected to a second voltage node, a drain terminal of the first transistor T1 is connected to a drain terminal of the second transistor T2, and a substrate terminal of the second transistor T2 is connected to the second voltage node.

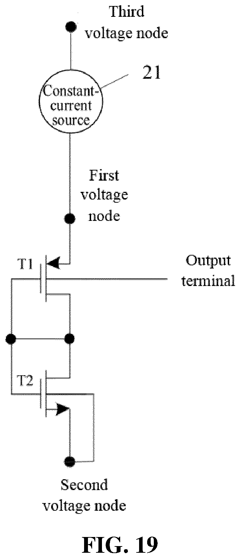

In this implementation mode, FIG. 19 is a schematic structural diagram of a potential generation circuit according to an embodiment not covered by the invention. As shown in FIG. 19, based on the circuit shown in FIG. 18, the potential generation circuit according to the embodiment further includes a constant-current source 21, a first terminal of the constant-current source 21 is connected to a first voltage node, and a second terminal of the constant-current source 21 is connected to a third voltage node.

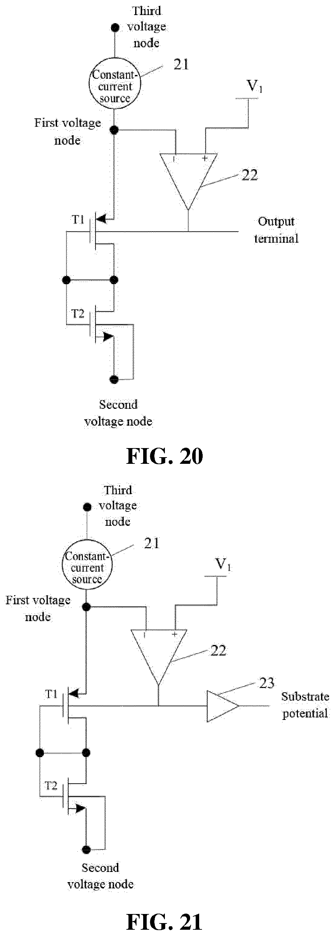

FIG. 20 is a schematic structural diagram of a potential generation circuit according to an embodiment not covered by the invention. As shown in FIG. 20, based on the circuit illustrated in FIG. 19, the potential generation circuit according to the embodiment may further include an error amplifier 22 which forms a feedback loop with the first transistor T1, here the substrate terminal of the first transistor T1 is connected to a voltage node of the first feedback loop.

As shown in FIG. 20, optionally, a negative input terminal of the error amplifier 22 is connected to a first voltage node, a positive input terminal of the error amplifier 22 is connected to a first reference voltage V₁, and an output terminal of the error amplifier 22 is connected to the substrate terminal of the first transistor T1.

In the embodiment, the first reference voltage Vi may be connected to a power supply end, and a potential of the third voltage node is greater than that of the first reference voltage V₁.

In the potential generation circuit shown in FIG. 20, the potential of the third voltage node is greater than that of the first reference voltage V1, and the potential of the first voltage node is less than that of the third voltage node. For example, the voltage of the third voltage node may be Vdd, and the first reference voltage Vi may be equal to Vcc, where Vdd is greater than Vcc.

The potential generation circuit shown in any of FIG. 18 to FIG. 20 is provided with the first transistor and the second transistor. The gate terminal of the first transistor is connected to the drain terminal thereof. The substrate terminal of the first transistor serves as the output terminal of the potential generation circuit. The gate terminal of the second transistor is connected to the drain terminal thereof. Since the potential of the substrate terminal of the first transistor changes along with the change of the first parameter, the output terminal can output a potential that changes along with the change of any of the power supply voltage, working temperature, and manufacturing process.

FIG. 21 is a schematic structural diagram of a potential generation circuit according to an embodiment not covered by the invention. As shown in FIG. 21, based on the potential generation circuit shown in FIG. 20, the potential generation circuit according to the embodiment may further include a buffer 23. The buffer 23 is connected to the output terminal and outputs a substrate potential. A value of the substrate potential is equal to a potential value of the substrate terminal of the first transistor T1. An input potential of the buffer 23 is equal to an output potential thereof. The buffer 23 is configured to improve drive capability of the potential of the substrate terminal of the first transistor T1, and can also isolate the substrate terminal of the first transistor T1 to prevent the potential of the substrate terminal of the first transistor T1 from being interfered.

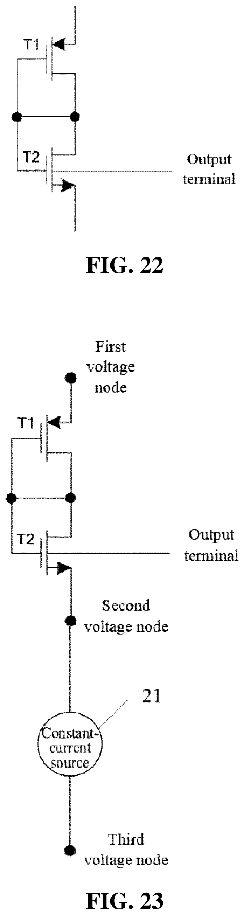

Another potential generation circuit is shown below with reference to FIG. 22 to FIG. 25. FIG. 22 is a schematic structural diagram of a potential generation circuit according to an embodiment not covered by the invention. As shown in FIG. 22, the potential generation circuit according to the embodiment may include a first transistor T1 and a second transistor T2. A potential of a substrate terminal of the second transistor T2 changes along with a change of a first parameter. The first parameter refers to any of power supply voltage, working temperature, and manufacturing process of the potential generation circuit.

A gate terminal of the first transistor T1 is connected to a drain terminal thereof. A gate terminal of the second transistor T2 is connected to a drain terminal thereof. The substrate terminal of the second transistor serves as an output terminal of the potential generation circuit.

Specifically, the potential of the substrate terminal of the second transistor T2 is a potential output from the output terminal. The potential of the substrate terminal of the second transistor T2 changes along with the change of the first parameter, and thus, the potential generation circuit provided in the embodiment can output a potential that changes along with a change of any of the power supply voltage, working temperature, and manufacturing process.

Specifically, if the first parameter refers to the power supply voltage or working temperature of the potential generation circuit, the potential of the substrate terminal of the second transistor T2 changes along with the change of the first parameter, which may specifically include: the potential of the substrate terminal of the second transistor T2 falls along with an increase of the first parameter and rises along with a decrease of the first parameter.

In an implementation mode, the first transistor T1 is a P-type transistor, and the second transistor T2 is an N-type transistor.

In an implementation mode, a source terminal of the first transistor T1 is connected to a first voltage node, a source terminal of the second transistor T2 is connected to a second voltage node, a drain terminal of the first transistor T1 is connected to a drain terminal of the second transistor T2, and a substrate terminal of the first transistor T1 is connected to the first voltage node.

In this implementation mode, FIG. 23 is a schematic structural diagram of a potential generation circuit according to an embodiment not covered by the invention. As shown in FIG. 23, based on the circuit shown in FIG. 22, the potential generation circuit according to the embodiment may further include a constant-current source 21. A first terminal of the constant-current source 21 is connected to a third voltage node, and a second terminal of the constant-current source 21 is connected to the second voltage node.

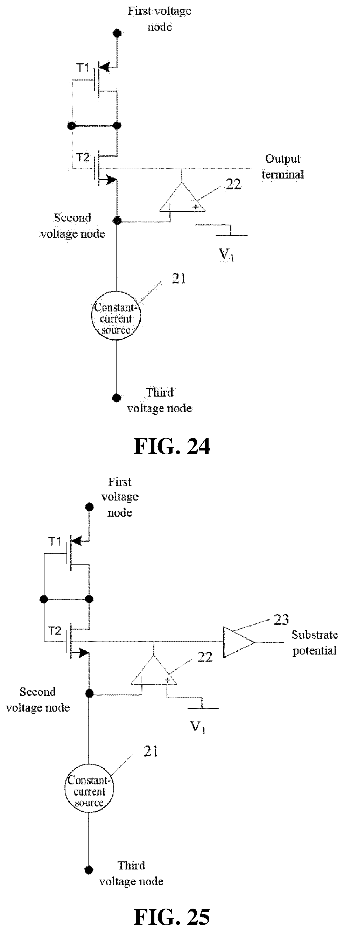

FIG. 24 is a schematic structural diagram of a potential generation circuit according to an embodiment not covered by the invention. As shown in FIG. 24, based on the circuit shown in FIG. 23, the potential generation circuit according to the embodiment may further include an error amplifier 22 which forms a feedback loop with the second transistor T2, here the substrate terminal of the second transistor T2 is connected to a voltage node of the first feedback loop.

As shown in FIG. 24, optionally, a negative input terminal of the error amplifier 22 is connected to the second voltage node, a positive input terminal of the error amplifier 22 is connected to a first reference voltage V₁, and an output terminal of the error amplifier 22 is connected to the substrate terminal of the second transistor T2.

In the embodiment, the first voltage node may be connected to a power supply end Vcc, the first reference voltage V₁ may be connected to ground Vss, and a potential of the third voltage node is less than that of the first reference voltage V₁.

In the potential generation circuit shown in FIG. 24, the first voltage node is connected to the power supply end Vcc, the first reference voltage Vi is connected to the ground Vss, and the potential of the third voltage node is less than that of Vi. For example, the potential of the third voltage node is less than 0, and the potential of the second voltage node is greater than that of the third voltage node.

The potential generation circuit shown in any of FIG. 22 to FIG. 24 is provided with the first transistor and the second transistor. The gate terminal of the first transistor is connected to the drain terminal thereof. The gate terminal of the second transistor is connected to the drain terminal thereof. The potential of the substrate terminal of the second transistor T2 changes along with the change of the first parameter. The substrate terminal of the second transistor serves as an output terminal of the potential generation circuit. Since the potential of the substrate terminal of the second transistor changes along with the change of the first parameter, the output terminal can output a potential that changes along with the change of any of the power supply voltage, working temperature, and manufacturing process.

FIG. 25 is a schematic structural diagram of a potential generation circuit according to an embodiment not covered by the invention. As shown in FIG. 25, based on the potential generation circuit shown in FIG. 24, the potential generation circuit according to the embodiment may further include a buffer 23. The buffer 23 is connected to the output terminal and outputs a substrate potential. A value of the substrate potential is equal to a potential value of the substrate terminal of the first second T2. An input potential of the buffer 23 is equal to an output potential thereof. The buffer 23 is configured to improve drive capability of the potential of the substrate terminal of the second transistor T2, and can also isolate the substrate terminal of the second transistor T2 to prevent the potential of the substrate terminal of the second transistor T2 from being interfered.

The structure of the potential generation circuit of this application will be described below in conjunction with the specific embodiments. The specific structure of the potential generation circuit of this application is not limited to any of the following structures.

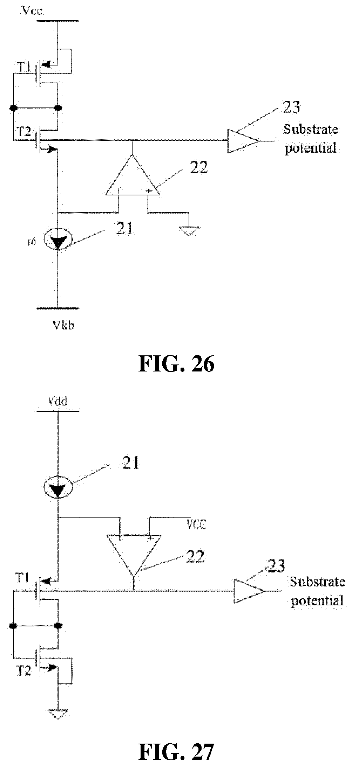

FIG. 26 is a schematic structural diagram of a potential generation circuit according to an embodiment not covered by the invention. As shown in FIG. 26, the potential generation circuit according to the embodiment may include a first transistor T1, a second transistor T2, a constant-current source 21, an error amplifier 22, and a buffer 23.

In this embodiment, the first transistor T1 is a P-type transistor, and the second transistor T2 is an N-type transistor. A gate terminal of the first transistor T1 is connected to a drain terminal thereof. A gate terminal of the second transistor T2 is connected to a drain terminal thereof. A source terminal of the first transistor T1 is connected to a power supply end Vcc. A source terminal of the second transistor T2 is connected to a first terminal of the constant-current source 21. The drain terminal of the first transistor T1 is connected to the drain terminal of the second transistor T2. A second terminal of the constant-current source 21 is connected to Vkb of which a potential is less than 0.

The error amplifier 22 and the second transistor T2 form a first feedback loop. A negative input terminal of the error amplifier 22 is connected to the source terminal of the second transistor T2 and the first terminal of the constant-current source 21. A positive input terminal of the error amplifier 22 is connected to ground. An output terminal of the first amplifier 22 is connected to a substrate terminal of the second transistor T2.

The second buffer 23 is connected to the substrate terminal of the second transistor T2 and outputs a substrate potential. A value of the substrate potential is equal to a potential value of the substrate terminal of the second transistor T2.

In this embodiment, the potential of the substrate terminal of the second transistor T2 changes along with a change of a first parameter. Specifically, the potential of the substrate terminal of the second transistor T2 falls along with an increase of the first parameter, and rises along with a decrease of the first parameter. The first parameter refers to any of the power supply voltage, working temperature and manufacturing process of the potential generation circuit.

Taking the first parameter referring to the working temperature as an example, the principle that the potential of the substrate terminal of the second transistor T2 changes with the change of the first parameter will be described below in detail.

A current flowing through the second transistor T2 is Id=µ*Cox*(W/L)*(Vgs-Vth)², where µ is an electronic mobility, and Vth is a threshold voltage. For example, with rise of the working temperature, the electronic mobility µ decreases, which may decrease the current Id flowing through the second transistor T2, and prolong delay time of a corresponding inverter. Here, if Vgs-Vth is adjusted to be greater, a current change caused by a decrease of the electronic mobility µ may be compensated. The specific adjusted value may be set according to actual requirements. In the potential generation circuit shown in FIG. 26, if temperature rises, the electronic mobility µ decreases, and the current Id flowing through the second transistor T2 decreases. In order to keep the current of the constant-current source constant, the substrate potential of the second transistor T2 needs to be decreased, and here the substrate potential decreases along with temperature rise.

When the first parameter refers to the power supply voltage and manufacturing process, changes of the power supply voltage and manufacturing process may cause a change of the current Id flowing through the second transistor T2, thereby resulting in a change of the delay time. The principle of compensation is similar to the foregoing principle, which will not be elaborated here.

FIG. 27 is a schematic structural diagram of a potential generation circuit according to an embodiment not covered by the invention. As shown in FIG. 27, the potential generation circuit according to the embodiment may include a first transistor T1, a second transistor T2, a constant-current source 21, an error amplifier 22, and a buffer 23.

In this embodiment, the first transistor T1 is a P-type transistor, and the second transistor T2 is an N-type transistor. A gate terminal of the first transistor T1 is connected to a drain terminal thereof. A gate terminal of the second transistor T2 is connected to a drain terminal thereof. A source terminal of the first transistor T1 is connected to a first terminal of the constant-current source 21. A source terminal of the second transistor T2 is connected to ground. The drain terminal of the first transistor T1 is connected to the drain terminal of the second transistor T2. A second terminal of the constant-current source 21 is connected to Vdd.

The error amplifier 22 and the first transistor T1 form a first feedback loop. A negative input terminal of the error amplifier 22 is connected to the source terminal of the first transistor T1 and the first terminal of the constant-current source 21. A positive input terminal of the error amplifier 22 is connected to a power supply end Vcc. An output terminal of the amplifier 22 is connected to a substrate terminal of the first transistor T1.

Vdd is greater than Vcc.

The buffer 23 is connected to the substrate terminal of the first transistor T1 and outputs a substrate potential. A value of the substrate potential is equal to a potential value of the substrate terminal of the first transistor T1.

In this embodiment, the potential of the substrate terminal of the first transistor T1 changes along with a change of a first parameter. Specifically, the potential of the substrate terminal of the first transistor T1 rises along with an increase of the first parameter, and decreases along with a decrease of the first parameter. The first parameter refers to any of the power supply voltage, working temperature, and manufacturing process of the potential generation circuit.

Taking the first parameter referring to the working temperature as an example, the principle that the potential of the substrate terminal of the first transistor T1 changes with the change of the first parameter will be described below in detail.

A current flowing through the first transistor T1 is Id=µ*Cox*(W/L)*(Vgs-Vth)², where µ is an electronic mobility, and Vth is a threshold voltage. For example, with rise of the working temperature, the electronic mobility µ decreases, which may decrease the current Id flowing through the first transistor T1, and prolong delay time of a corresponding inverter. Here, if Vgs-Vth is adjusted to be greater, a current change caused by a decrease of the electronic mobility µ may be compensated. The specific adjusted value may be set according to actual requirements. In the potential generation circuit shown in FIG. 26, if temperature rises, the electronic mobility µ decreases, and the current Id flowing through the first transistor T1 decreases. In order to keep the current of the constant-current source constant, the substrate potential of the first transistor T1 needs to be decreased, and here the substrate potential decreases along with temperature rise.

When the first parameter refers to the power supply voltage and manufacturing process, changes of the power supply voltage and manufacturing process may cause a change of the current Id flowing through the second transistor T2, thereby resulting in a change of the delay time. The principle of compensation is similar to the foregoing principle, which will not be elaborated here.

The embodiment of this application further provides a delay circuit, including the potential generation circuit shown in FIG. 18, or FIG. 19, or FIG. 20, or FIG. 21, or FIG. 27 and a delay unit. The delay unit includes a first inverter. The first inverter includes a fourth transistor and a fifth transistor. A substrate terminal of the fourth transistor is connected to the potential of the substrate terminal of the first transistor, and a substrate terminal of the fifth transistor is connected to the ground. The fourth transistor is a P-type transistor, and the fifth transistor is an N-type transistor.

Optionally, a ratio of a channel length of the first transistor to a channel length of the fourth transistor is denoted as H, a ratio of a channel length of the second transistor T2 to a channel length of the fifth transistor is denoted as L, a ratio of a channel width of the first transistor to a channel width of the fourth transistor is denoted as M, and a ratio of a channel width of the second transistor to a channel width of the fifth transistor is denoted as N, where H is equal to L, and M is equal to N. Optionally, H, L, M, and N may be 1. Optionally, the first transistor and the fourth transistor may be of the same type, and the second transistor and the fifth transistor may be of the same type.

In the delay circuit provided in the embodiment, since the potential of the first transistor in the potential generation circuit may change along with the change of any of the power supply voltage, working temperature, and manufacturing process, a substrate potential that changes along with the change of the first parameter may be provided to the substrate terminal of the P-type transistor in the inverter. Thus, a current flowing through the P-type transistor of the inverter may be adjusted, a change value of the current flowing through the P-type transistor of the inverter may be compensated, so that delay time T of the delay circuit may have less change, and control capability of the delay circuit to accuracy of the delay time is improved.

The delay circuit provided in the embodiment can be applied to scenarios requiring precise control on a rising edge delay time of the delay circuit. For example, the delay circuit can be applied to a Dynamic Random Access Memory (DRAM), which can simultaneously compensate for influences of the change of any of the power supply voltage, working temperature, and manufacturing process on the delay time, so that the delay time T may have less change, and control capability of the delay circuit to accuracy of the delay time is improved.

The embodiment of this application further provides a delay circuit, including the potential generation circuit shown in any of FIG. 22 to FIG. 26. The delay unit includes a first inverter. The first inverter includes a fourth transistor and a fifth transistor. A substrate terminal of the fourth transistor is connected to the potential of the substrate terminal of the first transistor, and a substrate terminal of the fifth transistor is connected to the power supply end. The fourth transistor is a P-type transistor, and the fifth transistor is an N-type transistor.

Optionally, a ratio of a channel length of the first transistor to a channel length of the fourth transistor is denoted as H, a ratio of a channel length of the second transistor T2 to a channel length of the fifth transistor is denoted as L, a ratio of a channel width of the first transistor to a channel width of the fourth transistor is denoted as M, and a ratio of a channel width of the second transistor to a channel width of the fifth transistor is denoted as N, where H is equal to L, and M is equal to N. Optionally, H, L, M, and N may be 1. Optionally, the first transistor and the fourth transistor may be of the same type, and the second transistor and the fifth transistor may be of the same type.

In the delay circuit provided in the embodiment, since the potential of the second transistor in the potential generation circuit may change along with the change of any of the power supply voltage, working temperature, and manufacturing process, a substrate potential that changes along with the change of the first parameter may be provided to the substrate terminal of the N-type transistor in the inverter. Thus, a current flowing through the N-type transistor of the inverter may be adjusted, a change value of the current flowing through the N-type transistor of the inverter may be compensated, so that a falling edge delay time T of the delay circuit may have less change, and control capability of the delay circuit to accuracy of the falling edge delay time is improved.

The delay circuit provided in this application can be applied to scenarios requiring precise control on a falling edge delay time of the delay circuit. For example, the delay circuit can be applied to a Dynamic Random Access Memory (DRAM), which can simultaneously compensate for an influence of the change of any of the power supply voltage, working temperature, and manufacturing process on the delay time, so that the delay time T may have less change, and control capability of the delay circuit to accuracy of the falling edge delay time is improved.

The embodiment of this application further provides a delay circuit, including a first potential generation circuit, and a second potential generation circuit, and a delay unit.

The first potential generation circuit is the potential generation circuit shown in FIG. 18, or FIG. 19, or FIG. 20, or FIG. 21, or FIG. 27.

The second potential generation circuit is the potential generation circuit shown in any of FIG. 22 to FIG. 26.

The delay unit includes a first inverter. The first inverter includes a fourth transistor and a fifth transistor. A substrate terminal of the fourth transistor is connected to the potential of the substrate terminal of the first transistor in the first potential generation circuit. A substrate terminal of the fifth transistor is connected to the potential of the substrate terminal of the second transistor in the second potential generation circuit. The fourth transistor is a P-type transistor, and the fifth transistor is an N-type transistor.

Optionally, a ratio of a channel length of the first transistor in the first potential generation circuit to a channel length of the fourth transistor is denoted as H1, a ratio of a channel length of the second transistor in the first potential generation circuit to a channel length of the fifth transistor is denoted as L1, a ratio of a channel width of the first transistor in the first potential generation circuit to a channel width of the fourth transistor is denoted as M1, and a ratio of a channel width of the second transistor in the first potential generation circuit to a channel width of the fifth transistor is denoted as N1, where H1 is equal to L1, and M1 is equal to N1. Optionally, H1, L1, M1, and N1 may be 1.

A ratio of a channel length of the first transistor in the second potential generation circuit to a channel length of the fourth transistor is denoted as H2, a ratio of a channel length of the second transistor in the second potential generation circuit to a channel length of the fifth transistor is denoted as L2, a ratio of a channel width of the first transistor in the second potential generation circuit to a channel width of the fourth transistor is denoted as M2, and a ratio of a channel width of the second transistor in the second potential generation circuit to a channel width of the fifth transistor is denoted as N2, where H2 is equal to L2, and M2 is equal to N2. Optionally, H2, L2, M2, and N2 may be 1.

The delay circuit provided in this application can be applied to scenarios requiring precise control on a rising edge delay time and a falling edge delay time of the delay circuit. For example, the delay circuit can be applied to a Dynamic Random Access Memory (DRAM), which can simultaneously compensate for an influence of the change of any of the power supply voltage, working temperature, and manufacturing process on the rising edge delay time and the falling edge delay time, so that the rising edge delay time T and the falling edge delay time T may have less change, and control capability of the delay circuit to accuracy of the rising edge delay time and the falling edge delay time is improved.

It is to be noted that in the delay circuit provided in the embodiment, connection relationships between the potential generation circuit shown in the foregoing two embodiments and the inverter in the delay unit may be set according to the rising edge delay and/or the falling edge delay achieved through the delay unit. For example, a certain delay circuit achieves a rising edge delay, the delay circuit includes an inverter, and the inverter includes a P-type transistor and an N-type transistor. A first potential generation circuit is arranged in the delay circuit, which can provide a substrate potential that changes along with the change of the first parameter to the substrate terminal of the P-type transistor in the inverter, so that the current flowing through the P-type transistor in the inverter may be adjusted, the change value of the current flowing through the P-type transistor in the inverter is compensated, and the rising edge delay time of the delay circuit may have less change. For another example, a certain delay circuit achieves a falling edge delay, the delay circuit includes an inverter, and the inverter includes a P-type transistor and an N-type transistor. A second potential generation circuit is arranged in the delay circuit, which can provide a substrate potential changing along with the change of the first parameter to the substrate terminal of the N-type transistor in the inverter, so that a current flowing through the N-type transistor in the inverter may be adjusted, the change value of the current flowing through the N-type transistor in the inverter is compensated, and the falling edge delay time of the delay circuit may have less change. For another example, a certain delay circuit achieves both a rising edge delay and a falling edge delay, the delay circuit includes an inverter, and the inverter includes a P-type transistor and an N-type transistor. A first potential generation circuit and a second potential generation circuit are arranged in the delay circuit. The first potential generation circuit can provide a substrate potential that changes along with the change of the first parameter to the substrate terminal of the P-type transistor in the inverter, so that a current flowing through the P-type transistor in the inverter may be adjusted, the change value of the current flowing through the P-type transistor in the inverter is compensated, and the rising edge delay time of the delay circuit may have less change. The second potential generation circuit can provide a substrate potential that changes along with the change of the first parameter to the substrate terminal of the N-type transistor in the inverter, so that the current flowing through the N-type transistor in the inverter may be adjusted, the change value of the current flowing through the N-type transistor in the inverter is compensated, and the falling edge delay time of the delay circuit may have less change. Therefore, both changes of the rising edge delay time and the falling edge delay time of the delay circuit are minor. Control capability of the delay circuit to accuracy of the delay time (including the rising edge delay time and the falling edge delay time) is improved.

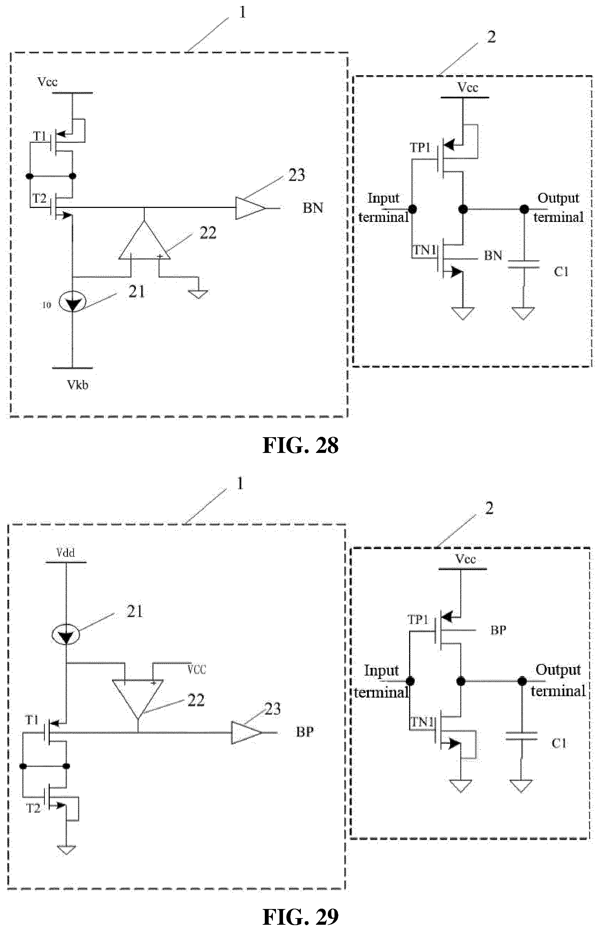

Examples of three delay circuits are given below with reference to FIG. 28 to FIG. 30. FIG. 28 is a schematic structural diagram of a delay circuit according to an embodiment of this application. As shown in FIG. 28, the delay circuit according to the embodiment includes a potential generation circuit 1 and a delay unit 2. The potential generation circuit 1 is the circuit shown in FIG. 26, its specific structure description may refer to the description in the embodiment shown in FIG. 26, which will not be elaborated here. The potential generation circuit 1 outputs a substrate potential BN. The delay unit 2 includes an inverter and a capacitor C1. The inverter includes a P-type transistor TP1 and an N-type transistor TN1. A substrate terminal of the P-type transistor TP1 is connected to a power supply end Vcc, and a substrate terminal of the N-type transistor TN1 is connected to the substrate potential BN. In the delay circuit according to the embodiment, the potential generation circuit 1 provides the substrate potential that changes along with the change of a first parameter to the substrate terminals of the N-type transistor in the delay unit 2, a change value of a falling edge delay time of the delay circuit may be adjusted, so that the falling edge delay time of the delay circuit may have less change. Thus, influences of the manufacturing process, power supply voltage, and working temperature of the delay circuit to the falling edge delay time T of the delay circuit may be reduced, the falling edge delay time T may have less change, and control capability of the delay circuit to accuracy of the falling edge delay time is improved.

FIG. 29 is a schematic structural diagram of a delay circuit according to an embodiment not covered by the invention. As shown in FIG. 29, the delay circuit according to the embodiment includes a potential generation circuit 1 and a delay unit 2. The potential generation circuit 1 is the circuit shown in FIG. 27, its specific structure description may refer to the description in the embodiment shown in FIG. 27, which will not be elaborated here. The potential generation circuit 1 outputs a substrate potential BP. The delay unit 2 includes an inverter and a capacitor C1. The inverter includes a P-type transistor TP1 and an N-type transistor TN1. A substrate terminal of the P-type transistor TP1 is connected to the substrate potential BP, and a substrate terminal of the N-type transistor TN1 is connected to the ground. In the delay circuit according to the embodiment, the potential generation circuit 1 provides the substrate potential that changes along with a change of a first parameter to the substrate terminal of the P-type transistor in the delay unit 2, a change value of a rising edge delay time of the delay circuit may be adjusted, so that the rising edge delay time of the delay circuit may have less change. Thus, influences of the manufacturing process, power supply voltage, and working temperature of the delay circuit to the rising edge delay time T of the delay circuit may be reduced, the rising edge delay time T may have less change, and control capability of the delay circuit to accuracy of the rising edge delay time is improved.

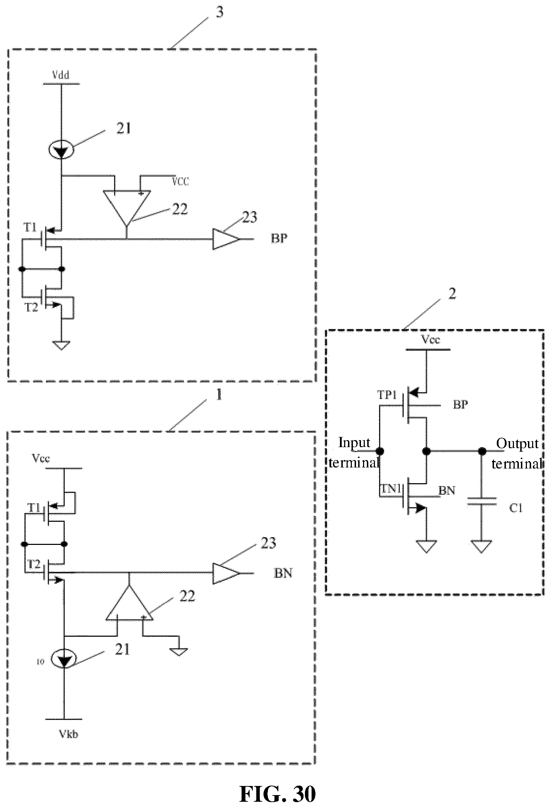

FIG. 30 is a schematic structural diagram of a delay circuit according to an embodiment not covered by the invention. As shown in FIG. 30, the delay circuit according to the embodiment includes a first potential generation circuit 1, a second potential generation circuit 3, and a delay unit 2. The first potential generation circuit 1 is the circuit shown in FIG. 27, its specific structure description may refer to the description in the embodiment shown in FIG. 27, which will not be elaborated here. The first potential generation circuit 1 outputs a substrate potential BN. The second potential generation circuit 3 is the circuit shown in FIG. 28, its specific structure description may refer to the description in the embodiment shown in FIG. 28, which will not be elaborated here. The second potential generation circuit 3 outputs a substrate potential BP. The delay unit 2 includes an inverter and a capacitor C1. The inverter includes a P-type transistor TP1 and an N-type transistor TN1. A substrate terminal of the P-type transistor TP1 is connected to the substrate potential BP output by the second potential generation circuit 3. A substrate terminal of the N-type transistor TN1 is connected to the substrate potential BN output by the first potential generation circuit 1. In the delay circuit according to the embodiment, the potential generation circuit 1 provides a substrate potential that changes along with a change of a first parameter to the substrate terminal of the N-type transistor in the delay unit 2, so that a change value of a rising edge delay time of the delay circuit may be adjusted, and the rising edge delay time of the delay circuit may have less change; the potential generation circuit 3 provides a substrate potential that changes along with the change of the first parameter to the substrate terminal of the P-type transistor in the delay unit 2, so that a change value of a falling edge delay time of the delay circuit may be adjusted, and the falling edge delay time of the delay circuit may have less change. Thus, influences of the manufacturing process, power supply voltage, and working temperature of the delay circuit to the delay time T (including the rising edge delay time and the falling edge delay time) may be reduced, so that the delay time T may have less change, and control capability of the delay circuit to accuracy of the delay time is improved.

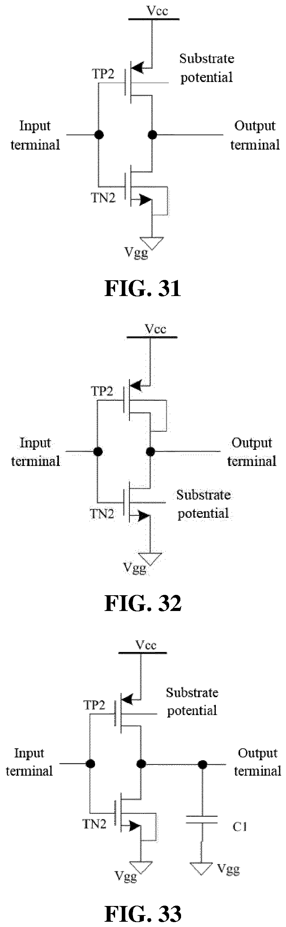

The embodiment of this application further provides an inverter. FIG. 31 is a schematic structural diagram of an inverter according to an embodiment of this application. As shown in FIG. 31, the inverter includes a P-type transistor TP2 and an N-type transistor TN2.

A source terminal of the P-type transistor TP2 is connected to a power supply end. A drain terminal of the P-type transistor TP2 is connected to a drain terminal of the N-type transistor TN2. A source terminal of the N-type transistor TN2 is connected to ground. A gate terminal of the P-type transistor TP2 is connected to a gate terminal of the N-type transistor TN2 and serves as an input terminal of the inverter. The drain terminal of the P-type transistor TP2 serves as an output terminal of the inverter.

A substrate terminal of the P-type transistor TP2 is connected to the first substrate potential. A substrate terminal of the N-type transistor TN2 is connected to the ground. The substrate potential changes along with a change of a first parameter. The first parameter refers to any of power supply voltage, working temperature, and manufacturing process of the inverter.

If the first parameter refers to the power supply voltage or working temperature of the inverter, the substrate potential rises along with an increase of the first parameter and falls along with a decrease of the first parameter.

In the inverter provided in the embodiment, since the substrate potential may change along with the change of any of the power supply voltage, working temperature, and manufacturing process, a substrate potential that changes along with the change of the first parameter may be provided to the substrate terminal of the P-type transistor TP2. Thus, a current flowing through the P-type transistor TP2 may be adjusted, a change value of the current flowing through the P-type transistor TP2 may be compensated, so that a rising edge delay time T of the inverter may have less change, and control capability of the inverter to accuracy of the rising edge delay time is improved.

FIG. 32 is a schematic structural diagram of an inverter according to an embodiment not covered by the invention. As shown in FIG. 32, the inverter includes a P-type transistor TP2 and an N-type transistor TN2. A source terminal of the P-type transistor TP2 is connected to a power supply end. A drain terminal of the P-type transistor TP2 is connected to a drain terminal of the N-type transistor TN2. A source terminal of the N-type transistor TN2 is connected to ground. A gate terminal of the P-type transistor TP2 is connected to a gate terminal of the N-type transistor TN2 and serves as an input terminal of the inverter. The drain terminal of the P-type transistor TP2 serves as an output terminal of the inverter.

A substrate terminal of the N-type transistor TN2 is connected to the first substrate potential. A substrate terminal of the P-type transistor TP2 is connected to the power supply end. The substrate potential changes along with a change of a first parameter. The first parameter refers to any of the power supply voltage, working temperature, and manufacturing process of the inverter.

If the first parameter refers to the power supply voltage or working temperature of the inverter, the substrate potential falls along with an increase of the first parameter and rises along with a decrease of the first parameter.

In the inverter provided in the embodiment, since the substrate potential may change along with the change of any of the power supply voltage, working temperature, and manufacturing process, a substrate potential that changes along with the change of the first parameter may be provided to the substrate terminal of the N-type transistor TN2. Thus, a current flowing through the N-type transistor TN2 may be adjusted, a change value of the current flowing through the N-type transistor TN2 may be compensated, a falling edge delay time T of the inverter may have less change, and control capability of the inverter to accuracy of the falling edge delay time is improved.

The embodiment of this application further provides a delay circuit. FIG. 33 is a schematic structural diagram of a delay circuit according to an embodiment of this application. As shown in FIG. 33, the delay circuit according to the embodiment may include the inverter shown in FIG. 31 and a capacitor C1. One terminal of the capacitor C1 is connected to ground. In an implementation mode, the capacitor C1 may be a capacitor array.

In the delay circuit provided in the embodiment, a change value of a current flowing through the P-type transistor TP2 of the inverter may be compensated so that a rising edge delay time T of the inverter may have less change, further a rising edge delay time T of the delay circuit may have less change, and control capacitor of the delay circuit to accuracy of the rising edge delay time is improved.

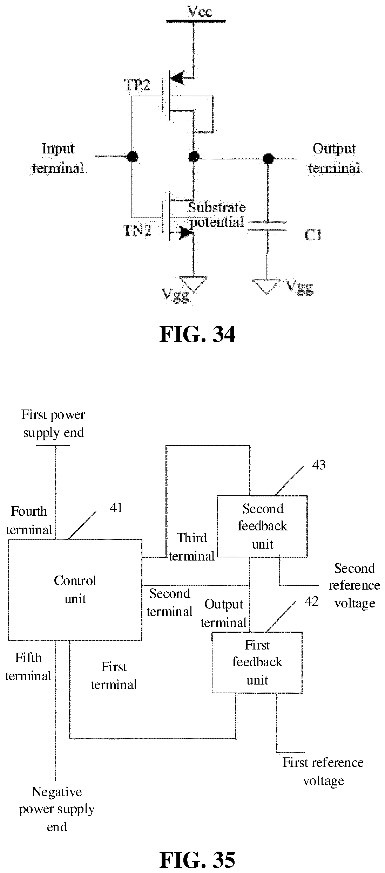

The embodiment of this application further provides a delay circuit. FIG. 34 is a schematic structural diagram of a delay circuit according to an embodiment of this application. As shown in FIG. 34, the delay circuit according to the embodiment may include the inverter shown in FIG. 32 and a capacitor C1. One terminal of the capacitor C1 is connected to ground. In an implementation mode, the capacitor C1 may be a capacitor array.

In the delay circuit provided in the embodiment, a change value of a current flowing through the N-type transistor TNP2 of the inverter may be compensated so that a falling edge delay time T of the inverter may have less change, further a falling edge delay time T of the delay circuit may have less change, and control capacitor of the delay circuit to accuracy of the falling edge delay time is improved.

The embodiment of this application further provides a logic gate circuit, including a P-type transistor and an N-type transistor. A substrate terminal of the P-type transistor is connected to a substrate potential. A substrate terminal of the N-type transistor is connected to ground. The substrate potential changes along with a change of a first parameter, so that a change value, changing along with the change of the first parameter, of delay time, from an input terminal to an output terminal, of the logic gate circuit is within a first range. The first parameter refers to any of the power supply voltage, working temperature, and manufacturing process of the of the logic gate circuit.

Specifically, the first range is a small range, for example, a range close to 0. For example, the first range is 1% or 3% or 5%, so that a rising edge delay time, from the input terminal to the output terminal, of the logic gate circuit may have less change during changing of any of the power supply voltage, operating temperature and manufacturing process, and control capability of the logic gate circuit to accuracy of the rising edge delay time is improved.

The embodiment of this application further provides a logic gate circuit, including a P-type transistor and an N-type transistor. A substrate terminal of the N-type transistor is connected to a substrate potential. A substrate terminal of the P-type transistor is connected to a power supply end. The substrate potential changes along with a change of a first parameter, so that a change value, changing along with the change of the first parameter, of delay time, from an input terminal to an output terminal, of the logic gate circuit is within a first range. The first parameter refers to any of the power supply voltage, working temperature, and manufacturing process of the logic gate circuit.

Specifically, the first range is a small range, for example, a range close to 0. For example, the first range is 1% or 3% or 5%, so that the falling edge delay time, from the input terminal to the output terminal, of the logic gate circuit may have less change during changing of any of the power supply voltage, operating temperature and manufacturing process, and control capability of the logic gate circuit to accuracy of the falling edge delay time is improved.

### Embodiment 3

FIG. 35 is a schematic structural diagram of a control circuit according to an embodiment not covered by the invention. As shown in FIG. 35, the control circuit according to the embodiment may include a control unit 41, a first feedback unit 42, and a second feedback unit 43. The first feedback unit 42 is configured to output a first feedback signal according to a voltage of the control unit 41 and a first reference voltage. A first terminal of the first feedback unit 42 is connected to a first terminal of the control unit. A second terminal of the first feedback unit 42 serves as an input terminal of the first reference voltage. An output terminal of the first feedback unit 42 is connected to a second terminal of the control unit 41 and a first terminal of the second feedback unit 43.

The second feedback unit 43 is configured to output a second feedback signal according to an output voltage of the first feedback unit 42 and a second reference voltage. The second terminal of the second feedback unit 43 serves as an input terminal of the second reference voltage. An output terminal of the second feedback unit 43 is connected to a third terminal of the control unit 41.

The control unit 41 is configured to adjust a voltage of the second terminal of the control unit 41 according to the first feedback signal, and adjust a voltage of the third terminal of the control unit 41 according to the second feedback signal, so as to allow a change value, changing along with a first parameter, of a current of the control unit 41 to be within a first range. The first parameter includes at least one of manufacturing process, power supply voltage, or working temperature of the control circuit. A fourth terminal of the control unit 41 is connected to a first power supply end, and a fifth terminal of the control unit 41 is connected to a negative power supply end. Specifically, the first range is a small range, for example, a range close to 0. For example, the first range is 1%, or 3%, or 5%, so that the change, along with the first parameter, of the current of the control unit 41 is minor.

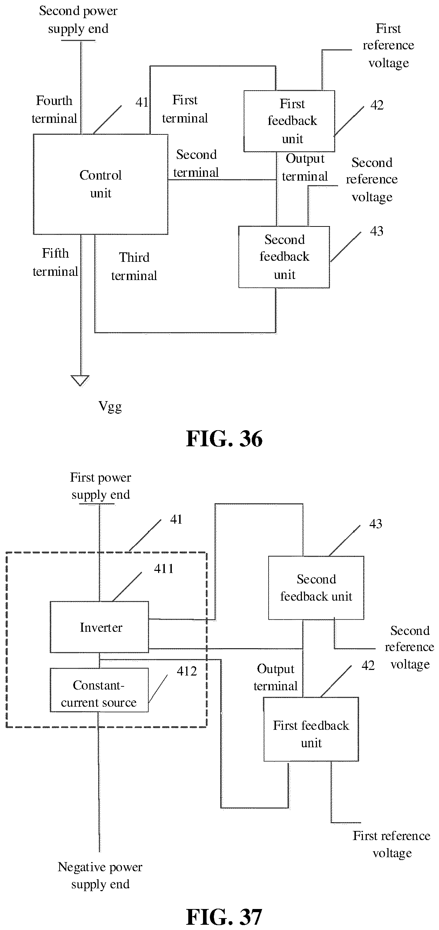

FIG. 36 is a schematic structural diagram of a control circuit according to an embodiment not covered by the invention. As shown in FIG. 36, the difference of this embodiment over the embodiment shown in FIG. 35 lies in: a fourth terminal of the control unit 41 is connected to a second power supply end, and a fifth terminal of the control unit 41 is connected to ground Vgg.

The control circuit shown in FIG. 35 and FIG. 36 is provided with the control unit, the first feedback unit, and the second feedback unit. The first terminal of the first feedback unit is connected to the first terminal of the control unit. The second terminal of the first feedback unit serves as an input terminal of the first reference voltage. An output terminal of the first feedback unit is connected to the second terminal of the control unit and the first terminal of the second feedback unit. The second terminal of the second feedback unit serves as an input terminal of the second reference voltage. An output terminal of the second feedback unit is connected to the third terminal of the control unit. The first feedback unit is configured to output a first feedback signal according to a voltage of the control unit and a first reference voltage. The second feedback unit is configured to output a second feedback signal according to an output voltage of the first feedback unit and a second reference voltage. The control unit is configured to adjust a voltage of a second terminal of the control unit according to the first feedback unit and adjust a voltage of a third terminal of the control unit according to the second feedback signal, so as to allow a change value, changing along with a first parameter, of a current of the control unit to be within a first range, herein the first parameter refers to any of the power supply voltage, working temperature, and manufacturing process, such that the second terminal and the third terminal of the control unit can respectively output a voltage that changes along with a change of any of the power supply voltage, working temperature, and manufacturing process.

FIG. 37 is a schematic structural diagram of a control circuit according to an embodiment not covered by the invention. As shown in FIG. 37, based on the circuit shown in FIG. 35, the control circuit according to the embodiment further includes: the control unit 41 may include an inverter 411 and a constant-current source 412, herein a first terminal of the inverter 411 is connected to a first power supply end.

A first terminal of the constant-current source 412 is connected to a second terminal of the inverter 411. A second terminal of the constant-current source 412 is connected to a negative power supply end.

An input terminal of the inverter 411 is in short circuit with an output terminal thereof.

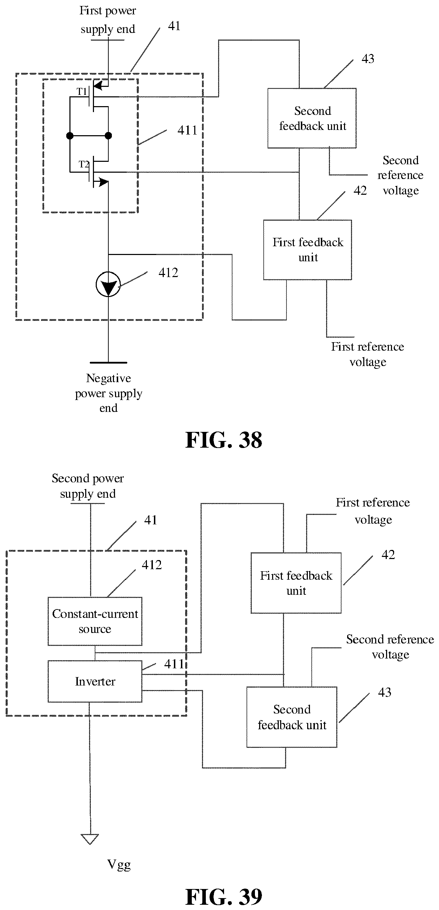

FIG. 38 is a schematic structural diagram of a control circuit according to an embodiment not covered by the invention. As shown in FIG. 38, based on the circuit shown in FIG. 37, the control circuit according to the embodiment further includes: an inverter 411 includes a first transistor T1 and a second transistor T2. A substrate terminal of the first transistor T1 is connected to an output terminal of a second feedback unit 43, and a substrate terminal of the second transistor T2 is connected to an output terminal of a first feedback unit 42.

A first terminal of the first transistor T1 is connected to a first power supply end, a second terminal of the first transistor T1 is connected to a first terminal of the second transistor T2, a control terminal of the first transistor T1 is connected to a control terminal of the second transistor T2, and a second terminal of the second transistor T2 is connected to a first terminal of the constant-current source 412.

In the embodiment, the control unit 41 is configured to adjust the voltage of the substrate terminal of the second transistor T2 according to the first feedback signal, and adjust the voltage of the substrate terminal of the first transistor T1 according to the second feedback signal.

In the control circuit according to the embodiment, the control unit is configured to adjust the voltage of the substrate terminal of the second transistor according to the first feedback unit, and adjust the voltage of the substrate terminal of the first transistor according to the second feedback signal, so as to allow a change value, changing along with a first parameter, of a current of the control unit to be within a first range, so that the substrate terminal of the first transistor and the substrate terminal of the second transistor can respectively output a voltage that changes along with a change of any of the power supply voltage, working temperature, and manufacturing process.

FIG. 39 is a schematic structural diagram of a control circuit according to an embodiment not covered by the invention. As shown in FIG. 39, based on the circuit shown in FIG. 36, the control circuit according to the embodiment further includes: the control unit 41 may include an inverter 411 and a constant-current source 412, and a first terminal of the inverter 411 is connected to ground.

A first terminal of the constant-current source 412 is connected to a second terminal of the inverter 411. A second terminal of the constant-current source 412 is connected to a second power supply end.

An input terminal of the inverter 411 is in short circuit with an output terminal thereof.

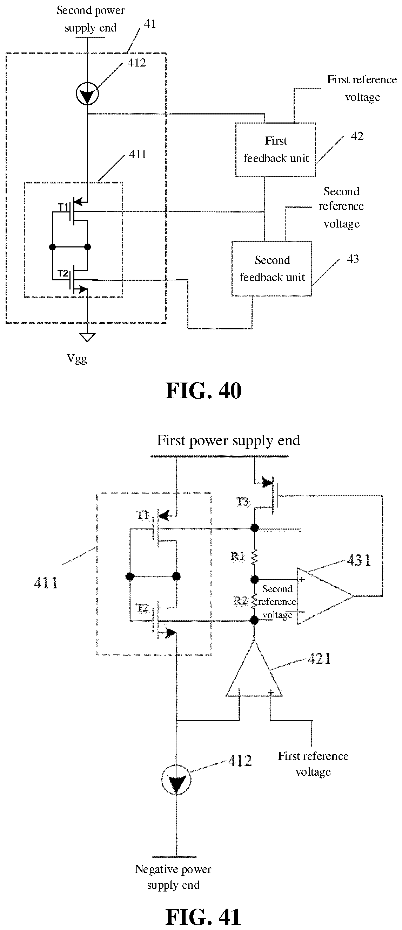

FIG. 40 is a schematic structural diagram of a control circuit according to an embodiment not covered by the invention. As shown in FIG. 40, based on the circuit shown in FIG. 39, the control circuit according to the embodiment further includes: an inverter 411 includes a first transistor T1 and a second transistor T2; a substrate terminal of the first transistor T1 is connected to an output terminal of the first feedback unit, and a substrate terminal of the second transistor T2 is connected to an output terminal of the second feedback unit 43.

A first terminal of the first transistor T1 is connected to a first terminal of the constant-current source, a second terminal of the first transistor T1 is connected to a first terminal of the second transistor T2, a control terminal of the first transistor T1 is connected to a control terminal of the second transistor T2, and a second terminal of the second transistor T2 is connected to ground.

In the embodiment, the control unit 41 is configured to adjust the voltage of the substrate terminal of the second transistor T2 according to the first feedback signal, and adjust the voltage of the substrate terminal of the first transistor T1 according to the second feedback signal.

In the control circuit according to the embodiment, the control unit is configured to adjust the voltage of the substrate terminal of the second transistor according to the first feedback unit, and adjust the voltage of the substrate terminal of the first transistor according to the second feedback signal, so as to allow a change value, changing along with a first parameter, of a current of the control unit to be within a first range, so that the substrate terminal of the first transistor and the substrate terminal of the second transistor can respectively output a voltage that changes along with a change of any of the power supply voltage, working temperature, and manufacturing process.

In the control circuit shown in FIG. 38 and FIG. 40, the first transistor is a P-type transistor, and the second transistor is an N-type transistor.

The specifically implementable structures of the first feedback unit and the second feedback unit will be described in detail below with reference to the accompany drawings.

FIG. 41 is a schematic structural diagram of a control circuit according to an embodiment not covered by the invention. As shown in FIG. 41, based on the circuit shown in FIG. 38, the control circuit according to the embodiment further includes: a first feedback unit 42 includes a first error amplifier 421; a negative input terminal of the first feedback unit 421 is connected to a first terminal of the control unit 41; a positive input terminal of the first feedback unit 421 serves as an input terminal of the first reference voltage; an output terminal of the first feedback unit 421 is connected to a second terminal of the control unit 41 and a first terminal of a second feedback unit 43.

As shown in FIG. 41, further, the second feedback unit 43 includes a second error amplifier 431, a first resistor R1, a second resistor R2, and a third transistor T3. A negative input terminal of the second error amplifier serves as an input terminal of the second reference voltage. A positive input terminal of the second error amplifier 431 is connected to a first terminal of the first resistor R1 and a first terminal of the second resistor R2. An output terminal of the second error amplifier 431 is connected to a control terminal of the third transistor T3.

A second terminal of the first resistor R1 is connected to a first terminal of the third transistor T3 and a third terminal of the control unit 41.

A second terminal of the second resistor R2 is connected to an output terminal of the first feedback unit and a second terminal of the control unit 41.

A second terminal of the third transistor is connected to a first power supply end.

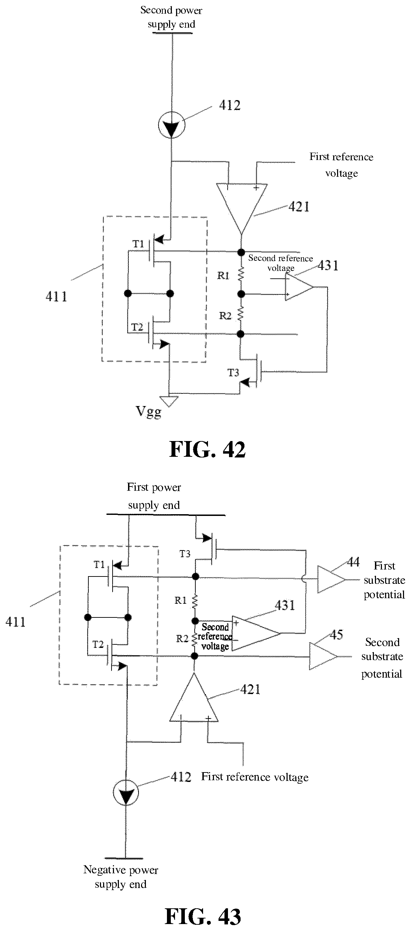

FIG. 42 is a schematic structural diagram of a control circuit according to an embodiment not covered by the invention. As shown in FIG. 42, based on the circuit shown in FIG. 40, the control circuit according to the embodiment further includes: a first feedback unit 42 includes a first error amplifier 421; a negative input terminal of the first feedback unit 421 is connected to a first terminal of the control unit 41; a positive input terminal of the first feedback unit 421 serves as an input terminal of the first reference voltage; an output terminal of the first feedback unit 421 is connected to a second terminal of the control unit 41 and a first terminal of a second feedback unit 43.

As shown in FIG. 42, further, the second feedback unit 43 includes a second error amplifier 431, a first resistor R1, a second resistor R2, and a third transistor T3. A negative input terminal of the second error amplifier 431 serves as an input terminal of the second reference voltage. A positive input terminal of the second error amplifier 431 is connected to a first terminal of the first resistor R1 and a first terminal of the second resistor R2. An output terminal of the second error amplifier 431 is connected to a control terminal of the third transistor T3.

A second terminal of the first resistor R1 is connected to an output terminal of the first feedback unit and a second terminal of the control unit 41.

A second terminal of the second resistor R2 is connected to a first terminal of the third transistor T3 and a third terminal of the control unit 41.

A second terminal of the third transistor is connected to ground.

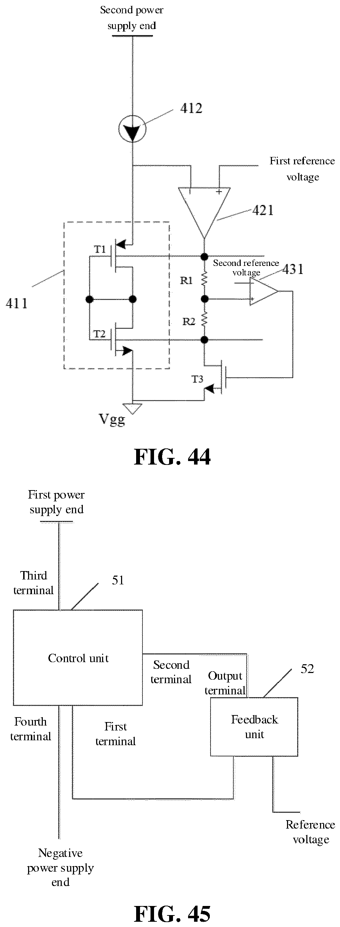

The control circuit shown in FIG. 41 or FIG. 42 may further include a first buffer and a second buffer. FIG. 43 is a schematic structural diagram of a control circuit according to an embodiment not covered by the invention. FIG. 44 is a schematic structural diagram of a control circuit according to an embodiment not covered by the invention. As shown in FIG. 43 and FIG. 44, based on the control circuit shown in FIG. 41 or FIG. 42, a first buffer 44 and a second buffer 45 may also be included in the control circuit. The first buffer 44 is connected to a substrate terminal of a first transistor T1 and outputs a first substrate voltage. A value of the first substrate voltage is equal to a voltage value of the substrate terminal of the first transistor T1. An input voltage and an output voltage of the first buffer 44 are the same. The first buffer 44 is configured to improve drive capability of the potential of the substrate terminal of the first transistor T1, and can also isolate the substrate terminal of the first transistor T1 to prevent the potential of the substrate terminal of the first transistor T1 from being interfered.

The second buffer 45 is connected to a substrate terminal of a second transistor T2 and outputs a second substrate voltage. A value of the second substrate voltage is equal to a voltage value of the substrate terminal of the first transistor T1. The second buffer 45 is configured to improve drive capability of the potential of the substrate terminal of the second transistor T2, and can also isolate the substrate terminal of the second transistor T2 to prevent the potential of the substrate terminal of the second transistor T2 from being interfered.

It is to be noted that in the control circuit shown in FIG. 35 to FIG. 44, the voltage of the first power supply end is, for example, Vcc, the second reference voltage may be Vcc/2, the voltage of the negative power supply end may be a value less than 0, and the first reference voltage may be 0.

The voltage of the second power supply end is greater than the first reference voltage. The value of the second reference voltage may be a half of the first reference voltage. For example, the voltage of the second power supply end is Vdd, the first reference voltage is Vcc, where Vdd is greater than Vcc, and the value of the second reference voltage may be Vcc/2.

The structure of the control circuit of this application will be described below in conjunction with the specific embodiments. The specific structure of the control circuit of this application is not limited to any of the following structures.

Specifically, the specific structure of the control circuit according to the embodiment may refer to the circuit structures shown in FIG. 11 and FIG. 12. The potential generation circuit shown in FIG. 11 and FIG. 12 is the control circuit in the embodiment, and the two have the same working principle. Refer to the description of the embodiment shown in FIG. 11 and FIG. 12 for details, which will not be elaborated here.

The embodiment of this application further provides a delay circuit, including the control circuit shown in any of FIG. 35 to FIG. 44 and a delay unit. The second terminal of the control unit in the control circuit is connected to a first terminal of the delay unit, and the third terminal of the control unit is connected to a second terminal of the delay unit. The control circuit is configured to control a change value, changing along with the first parameter, of the rising edge delay time and/or the falling edge delay time of the delay unit to be within the first range.

Optionally, the delay unit includes an inverter, and the inverter includes a fourth transistor and a fifth transistor. The third terminal of the control unit is connected to a substrate terminal of the fourth transistor. The second terminal of the control unit is connected to a substrate terminal of the fifth transistor.

Optionally, the fourth transistor is a P-type transistor, and the fifth transistor is an N-type transistor.

In the embodiment, optionally, the control circuit in the delay circuit is the control circuit shown in any of FIG. 38, or FIG. 40, or FIG. 41 to FIG. 44, a ratio of a channel length of the first transistor to a channel length of the fourth transistor is denoted as H, a ratio of a channel length of the second transistor to a channel length of the fifth transistor is denoted as L, a ratio of a channel width of the first transistor to a channel width of the fourth transistor is denoted as M, and a ratio of a channel width of the second transistor to a channel width of the fifth transistor is denoted as N, where H is equal to L, and M is equal to N.

Thus, in the delay circuit provided in the embodiment, the second terminal and the third terminal of the control unit can respectively output a voltage that changes along with the change of the first parameter (any of the power supply voltage, working temperature, and manufacturing process). A first substrate voltage that changes along with the change of the first parameter may be provided to the substrate terminal of the fourth transistor, and a second substrate voltage that changes along with the change of the first parameter may be provided to the substrate terminal of the fifth transistor. Thus, a change value, changing along with the change of the first parameter, of a current flowing through the two transistors of the inverter may be adjusted to be within a first range, the change value of the current flowing through the two transistors of the inverter may be compensated, delay time T of the delay circuit may have less change, and control capability of the delay circuit to accuracy of the delay time is improved.

It is to be noted that, in the embodiment of this application, connection relationships between the control circuit and the inverters may be set according to the number of the inverters included in the delay circuit and the requirements for compensation of the delay time. A substrate terminal of a P-type transistor in each inverter is connected to a substrate terminal of a P-type transistor of the control circuit, so that a change value of a rising edge delay time of the delay circuit may be adjusted; a substrate terminal of an N-type transistor in the inverter is connected to a substrate terminal of an N-type transistor of the control circuit, so that a change value of a falling edge delay time of the delay circuit may be adjusted. Specifically, the connection relationships between the control circuit and the inverters may be set according to the change value of the rising edge and/or falling edge delay time required to be adjusted. The control circuit provided in the embodiment of this application can be applied to the delay circuit requiring both the rising edge and/or the falling edge delay, can reduce influences of the manufacturing process, power supply voltage, and working temperature of the delay circuit to the delay time T of the delay circuit, so that the delay time T (including the rising edge delay time and/or the falling edge delay time) may have less change, and control capability of the delay circuit to accuracy of the delay time is improved.

FIG. 13 to FIG. 15 show examples of the delay circuit in two types, which are also adaptable to the embodiment. The potential generation circuit shown in FIG. 13 to FIG. 15 is the specific control circuit in the embodiment. Refer to specific descriptions in FIG. 15 to FIG. 18 for details, which will not be elaborated here.

### Embodiment 4

FIG. 45 is a schematic structural diagram of a control circuit according to an embodiment not covered by the invention. As shown in FIG. 45, the control circuit according to the embodiment may include a control unit 51 and a feedback unit 52.

The feedback unit 52 is configured to output a feedback signal according to a voltage of the control unit 51 and a reference voltage, a first terminal of the feedback unit is connected to a first terminal of the control unit 51, a second terminal of the feedback unit serves as an input terminal of the reference voltage, and an output terminal of the feedback unit is connected to a second terminal of the control unit 52.

The control unit 51 is configured to adjust a voltage of the second terminal of the control unit 51 according to the feedback signal so as to allow a change value, changing along with a first parameter, of a current of the control unit to be within a first range. The first parameter includes at least one of manufacturing process, power supply voltage, or working temperature of the control circuit. A third terminal of the control unit 51 is connected to a power supply end, and a fourth terminal of the control unit 51 is connected to a negative power supply end.

Specifically, the first range is a small range, for example, a range close to 0. For example, the first range is 1%, or 3%, or 5%, so that the change, along with the first parameter, of the current of the control unit 41 is minor.

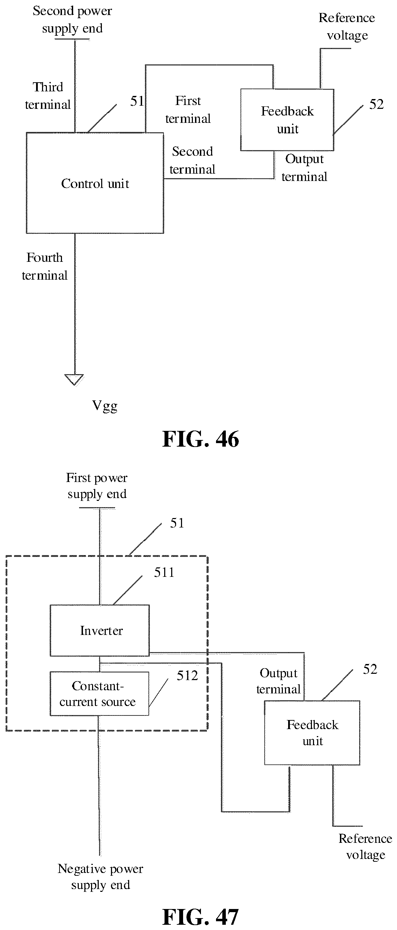

FIG. 46 is a schematic structural diagram of a control circuit according to an embodiment not covered by the invention. As shown in FIG. 46, the difference of this embodiment over the embodiment shown in FIG. 45 lies in: a third terminal of the control unit 51 is connected to a second power supply end, and a fourth terminal of the control unit 51 is connected to ground Vgg.

The control circuit shown in FIG. 45 and FIG. 46 is provided with the control unit and the feedback unit. The feedback unit is configured to output a feedback signal according to a voltage of the control unit and a reference voltage; the control unit is configured to adjust a voltage of a second terminal of the control unit according to the feedback unit so as to allow a change value, changing along with a first parameter, of a current of the control unit to be within a first range, herein the first parameter refers to any of the power supply voltage, working temperature, and manufacturing process, so that the second terminal of the control unit can output a voltage that changes along with a change of any of the power supply voltage, working temperature, and manufacturing process.

FIG. 47 is a schematic structural diagram of a control circuit according to an embodiment not covered by the invention. As shown in FIG. 47, based on the circuit shown in FIG. 45, the control circuit according to the embodiment further includes: the control unit 51 may include an inverter 511 and a constant-current source 512; a first terminal of the inverter 511 is connected to a first power supply end; a first terminal of the constant-current source 512 is connected to a second terminal of the inverter 511; a second terminal of the constant-current source 512 is connected to a negative power supply end; and an input terminal of the inverter 511 is connected to an output terminal thereof.

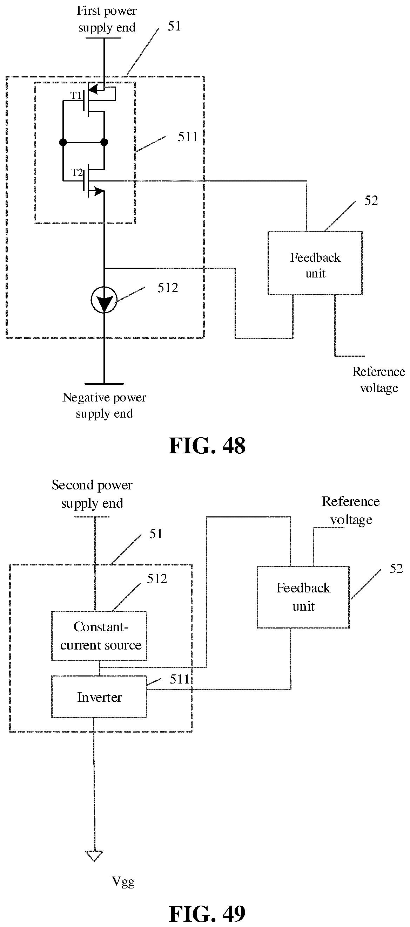

FIG. 48 is a schematic structural diagram of a control circuit according to an embodiment not covered by the invention. As shown in FIG. 48, based on the circuit shown in FIG. 47, the control circuit according to the embodiment further includes: the inverter 411 includes a first transistor T1 and a second transistor T2; a substrate terminal of the first transistor T1 is connected to a first power supply end; and a substrate terminal of the second transistor T2 is connected to an output terminal of the feedback unit 52.

A first terminal of the first transistor T1 is connected to the first power supply end, a second terminal of the first transistor T1 is connected to a first terminal of the second transistor T2, a control terminal of the first transistor T1 is connected to a control terminal of the second transistor T2, and a second terminal of the second transistor T2 is connected to a first terminal of the constant-current source.

In the embodiment, the control unit 41 is configured to adjust a voltage of the substrate terminal of the second transistor T2 according to the feedback signal.

In the control circuit according to the embodiment, the control unit is configured to adjust the voltage of the substrate terminal of the second transistor according to the feedback unit, so as to allow a change value, changing along with a first parameter, of a current of the control unit to be within a first range, herein the first parameter refers to any of the power supply voltage, working temperature, and manufacturing process, so that the substrate terminal of the second transistor can output a voltage that changes along with the change of any of the power supply voltage, working temperature, and manufacturing process.

FIG. 49 is a schematic structural diagram of a control circuit according to an embodiment not covered by the invention. As shown in FIG. 49, based on the circuit shown in FIG. 46, the control circuit according to the embodiment further includes: the control unit 51 may include an inverter 511 and a constant-current source 512; a first terminal of the inverter 511 is connected to ground; a first terminal of the constant-current source 512 is connected to a second terminal of the inverter 511; a second terminal of the constant-current source 512 is connected to a second power supply end; and an input terminal of the inverter 511 is connected to an output terminal thereof.

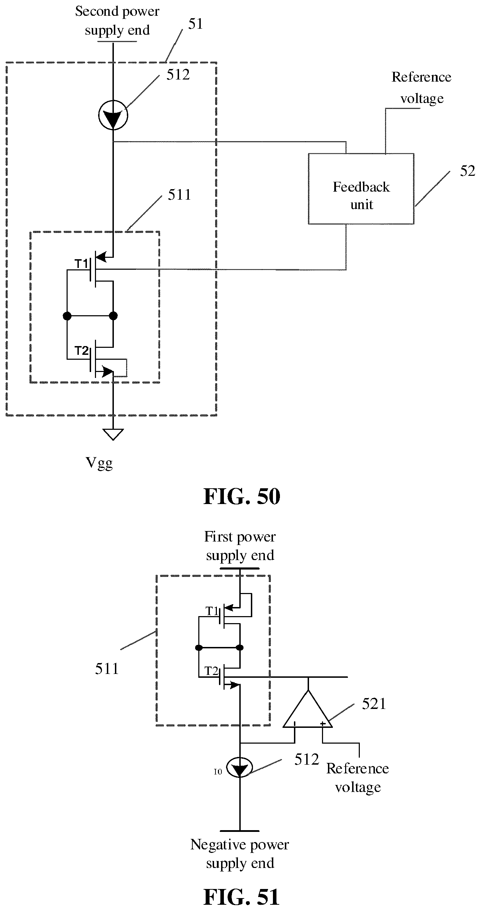

FIG. 50 is a schematic structural diagram of a control circuit according to an embodiment not covered by the invention. As shown in FIG. 50, based on the circuit shown in FIG. 49, the control circuit according to the embodiment further includes: the inverter 511 includes a first transistor T1 and a second transistor T2; a substrate terminal of the first transistor T1 is connected to an output terminal of the feedback unit; and a substrate terminal of the second transistor is connected to the ground.

A first terminal of the first transistor T1 is connected to a first terminal of the constant-current source, a second terminal of the first transistor T1 is connected to a first terminal of the second transistor T2, a control terminal of the first transistor T1 is connected to a control terminal of the second transistor T2, and a second terminal of the second transistor T2 is connected to the ground.

In the embodiment, the control unit 51 is configured to adjust a voltage of the substrate terminal of the first transistor T1 according to the feedback signal.

In the control circuit according to the embodiment, the control unit is configured to adjust the voltage of the substrate terminal of the first transistor according to the feedback unit, so as to allow a change value, changing along with a first parameter, of a current of the control unit to be within a first range, herein the first parameter refers to any of the power supply voltage, working temperature, and manufacturing process, so that the substrate terminal of the first transistor can output a voltage that changes along with the change of any of the power supply voltage, working temperature, and manufacturing process.

In the control circuit shown in FIG. 48 and FIG. 50, the first transistor is a P-type transistor, and the second transistor is an N-type transistor.

The specifically implementable structure of the feedback unit will be described in detail below with reference to the accompany drawings.

FIG. 51 is a schematic structural diagram of a control circuit according to an embodiment not covered by the invention. As shown in FIG. 51, based on the circuit shown in FIG. 48, the control circuit according to the embodiment further includes: a first feedback unit 52 includes an error amplifier 521; a negative input terminal of the feedback unit 521 is connected to a first terminal of the constant-current source 512 and the second terminal of the second transistor T2; a positive input terminal of the feedback unit 521 serves as a reference voltage input terminal; an output terminal of the feedback unit 521 is connected to a substrate terminal of the second transistor T2.

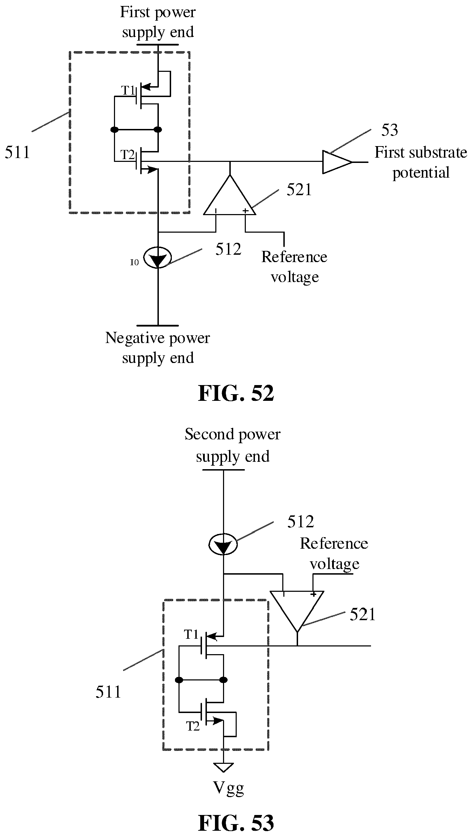

FIG. 52 is a schematic structural diagram of a control circuit according to an embodiment not covered by the invention. As shown in FIG. 52, based on the circuit shown in FIG. 51, the control circuit according to the embodiment may further include a buffer 53.

The buffer 53 is connected to the substrate terminal of the second transistor T2 and outputs a first substrate voltage. A value of the first substrate voltage is equal to a voltage value of the substrate terminal of the second transistor T2.

FIG. 53 is a schematic structural diagram of a control circuit according to an embodiment not covered by the invention. As shown in FIG. 53, based on the circuit shown in FIG. 50, the control circuit according to the embodiment further includes: a feedback unit 52 includes an error amplifier 521; a negative input terminal of the feedback unit 521 is connected to a first terminal of the constant-current source 512 and the first terminal of the first transistor T1; the negative input terminal of the feedback unit 521 serves as a reference voltage input terminal; an output terminal of the feedback unit 521 is connected to a substrate terminal of the first transistor T1.

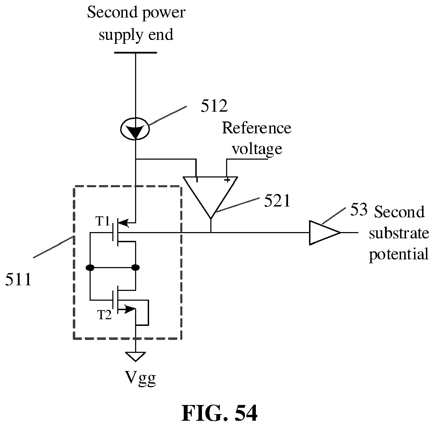

FIG. 54 is a schematic structural diagram of a control circuit according to an embodiment not covered by the invention. As shown in FIG. 54, based on the control circuit shown in FIG. 53, the control circuit according to the embodiment may further include a buffer 53. The buffer 53 is connected to the substrate terminal of the first transistor T1 and outputs a second substrate voltage. A value of the second substrate voltage is equal to a voltage value of the substrate terminal of the first transistor T1.

It is to be noted that in the control circuit shown in FIG. 45 to FIG. 54, the voltage of the first power supply end is, for example, Vcc, the second reference voltage may be Vcc/2, the voltage of the negative power supply end may be 0 or less than 0, and the first reference voltage may be 0.

The voltage of the second power supply end is greater than the first reference voltage. The value of the second reference voltage may be a half of the first reference voltage. For example, the voltage of the second power supply end is Vdd, the first reference voltage is Vcc, where Vdd is greater than Vcc, and the value of the second reference voltage may be Vcc/2.

The structure of the control circuit of this application will be described below in conjunction with the specific embodiments. The specific structure of the control circuit of this application is not limited to any of the following structures.

Specifically, the specific structure of the control circuit according to the embodiment may refer to the circuit structure shown in FIG. 26 and FIG. 27. The potential generation circuits shown in FIG. 26 and FIG. 27 are the control circuit in the embodiment, having the same working principle. Refer to the descriptions of the embodiment shown in FIG. 26 and FIG. 27 for detail, which will not be elaborated here.

The embodiment of this application further provides a delay circuit, including the control circuit shown in any of FIG. 45 to FIG. 54 and a delay unit. The second terminal of the control unit is connected to a first terminal of the delay unit. The control circuit is configured to control a change value, changing along with the first parameter, of a rising edge delay time and/or a falling edge delay time of the delay unit to be within the first range.

Optionally, the delay unit includes an inverter, the inverter includes a fourth transistor and a fifth transistor, and the second terminal of the control unit is connected to a substrate terminal of the fourth transistor or a substrate terminal of the fifth transistor.

Optionally, the fourth transistor is a P-type transistor, and the fifth transistor is an N-type transistor.

When a fifth terminal of the control unit is connected to the negative power supply end, the second terminal of the control unit is connected to a substrate terminal of the fifth transistor.

When the third terminal of the control unit is connected to the second power supply end and the fourth terminal of the control unit is connected to the ground, the second terminal of the control unit is connected to a substrate terminal of the fourth transistor.

In the embodiment, optionally, the control circuit in the delay circuit is the control circuit shown in any of FIG. 48, or FIG. 50, or FIG. 51 to FIG. 54, a ratio of a channel length of the first transistor to a channel length of the fourth transistor is denoted as H, a ratio of a channel length of the second transistor to a channel length of the fifth transistor is denoted as L, a ratio of a channel width of the first transistor to a channel width of the fourth transistor is denoted as M, and a ratio of a channel width of the second transistor to a channel width of the fifth transistor is denoted as N, where H is equal to L, and M is equal to N.

Thus, in the delay circuit provided in the embodiment, the second terminal of the control unit can output a voltage that changes along with the change of the first parameter (any of the power supply voltage, working temperature, and manufacturing process). A substrate voltage that changes along with the change of the first parameter may be provided to the substrate terminal of the fourth transistor, a change value, changing along with the change of the first parameter, of a current flowing through the fourth transistor of the inverter may be adjusted to be within a first range, and the change value of the current flowing through the fourth transistor of the inverter may be compensated, so that a rising edge delay time T of the delay circuit may have less change, and control capability of the delay circuit to accuracy of the rising edge delay time is improved.

Or, a first substrate voltage that changes along with the change of the first parameter may be provided to the substrate terminal of the fifth transistor, a change value, changing along with the first parameter, of a current flowing through the fifth transistor of the inverter may be adjusted to be within a first range, and the change value of the current flowing through the fifth transistor of the inverter may be compensated, so that a falling edge delay time T of the delay circuit may have less change, and control capability of the delay circuit to accuracy of the falling edge delay time is improved.

It is to be noted that in the delay circuit provided in the embodiment, connection relationships between the control circuit shown in the foregoing two embodiments and the inverter in the delay unit may be set according to the rising edge delay and/or the falling edge delay achieved through the delay unit. For example, a certain delay circuit achieves a rising edge delay, the delay circuit includes an inverter, and the inverter includes a P-type transistor and an N-type transistor. A first control circuit is arranged in the delay circuit, which can adjust a voltage of a substrate terminal of the P-type transistor in the inverter, so that a current flowing through the P-type transistor in the inverter may be adjusted to allow a change value, changing along with the first parameter, of the current flowing through the P-type transistor in the inverter to be within a first range, the change value of the current flowing through the P-type transistor in the inverter is compensated, and the rising edge delay time of the delay circuit may have less change. For another example, a certain delay circuit achieves a falling edge delay, the delay circuit includes an inverter, and the inverter includes a P-type transistor and an N-type transistor. A second control circuit is arranged in the delay circuit, which can adjust a voltage of a substrate terminal of the N-type transistor in the inverter, so that a current flowing through the N-type transistor in the inverter may be adjusted to allow a change value, changing along with the first parameter, of the current flowing through the N-type transistor in the inverter to be within a first range, the change value of the current flowing through the N-type transistor in the inverter is compensated, and the falling edge delay time of the delay circuit may have less change. For another example, a certain delay circuit achieves both a rising edge delay and a falling edge delay, the delay circuit includes an inverter, and the inverter includes a P-type transistor and an N-type transistor. A first control circuit and a second control circuit are arranged in the delay circuit. The first control circuit can adjust a voltage of a substrate terminal of the P-type transistor in the inverter, so that a current flowing through the P-type transistor in the inverter may be adjusted to allow a change value, changing along with the first parameter, of the current flowing through the P-type transistor in the inverter to be within the first range, the change value of the current flowing through the P-type transistor in the inverter is compensated, and the rising edge delay time of the delay circuit may have less change. The second control circuit can adjust a voltage of a substrate terminal of the N-type transistor in the inverter, so that the current flowing through the N-type transistor in the inverter may be adjusted to allow a change value, changing along with the first parameter, of the current flowing through the N-type transistor in the inverter to be within the first range, the change value of the current flowing through the N-type transistor in the inverter is compensated, and the falling edge delay time of the delay circuit may have less change. Therefore, both changes of the rising edge delay time and the falling edge delay time of the delay circuit are minor. Control capability of the delay circuit to accuracy of the delay time (including the rising edge delay time and the falling edge delay time) is improved.

FIG. 28 to FIG. 30 show two examples of the delay circuit, which are also applicable to this embodiment. The potential generation circuit shown in FIG. 28 to FIG. 30 is the specific control circuit in this embodiment. Refer to the specific descriptions in FIG. 28 to FIG. 30, which will not be elaborated here.

For example, the constant-current source in the above embodiments can be a mirror current source, and a current of a mirror terminal can be a current independent of temperature coefficients, or the current is unrelated to temperature, voltage, or the like. The constant-current source in the above embodiments may also be implemented in other manners.

It is to be noted at last: the above various embodiments are only used to illustrate the technical solutions of this application and not used to limit the same.

## Claims

1. A control circuit, comprising a control unit (41), a first feedback unit (42), and a second feedback unit (43), wherein:
the control unit (41) comprises an inverter (411) and a constant current source (412); a first terminal of the inverter (411) is connected to a first power supply end; a first terminal of the constant-current source (412) is connected to a second terminal of the inverter (411), and a second terminal of the constant-current source (412) is connected to a negative power supply end; and an input terminal of the inverter (411) is in short circuit with an output terminal of the inverter (411) and wherein the inverter comprises a first transistor (T1) and a second transistor (T2);
the first feedback unit (42) comprises a first operational amplifier (421), wherein the negative input of the first operational amplifier (421) is connected to the second terminal of the inverter (411); the positive input of the first operational amplifier (421) is connected to a first reference voltage and the output of the first operational amplifier (421) is connected to a thr substrate terminal of the second transistor (T2) and a first terminal of a first resistor (R2);
the second feedback unit (43) comprises a second operational amplifier (431), the first resistor (R2), a second resistor (R1) and a third transistor (T3), wherein the positive input of the second operational amplifier (431) is connected to the second terminal of the first resistor (R2) and a first terminal of the second resistor (R1); the negative input of the second operational amplifier (431) is connected to a second reference voltage; the second terminal of the second resistor (R1) is connected to the substrate terminal of the first transistor (T1) and to a first terminal of the third transistor (T3); and the output of the second operational amplifier (431) is connected to the gate of the third transistor (T3), whereby the second terminal of the third transistor (T3) is connected to the first power supply end;
and wherein,
the control circuit is configured to adjust the substrate voltage of the first transistor (T1) according to the output voltage of the second operational amplifier (431) and adjust the substrate voltage of the second transistor (T2) according to the output voltage of the first operational amplifier (421) to make a change value, changing along with a first parameter, of a current of the control unit (41) be within a first range; the first parameter comprises at least one of manufacturing process, power supply voltage, or working temperature of the control circuit.

2. The control circuit of claim 1, wherein a first terminal of the first transistor (T1) is connected to the first power supply end, a second terminal of the first transistor (T1) is connected to a first terminal of the second transistor (T2), a control terminal of the first transistor (T1) is connected to a control terminal of the second transistor (T2), and a second terminal of the second transistor (T2) is connected to the first terminal of the constant-current source (412).

3. The control circuit of claim 1, wherein the first transistor (T1) is a P-type transistor, and the second transistor (T2) is an N-type transistor.

4. The control circuit of claim 1, further comprising:
a first buffer (44), which is connected to the substrate terminal of the first transistor (T1) and outputs a first substrate voltage, a value of the first substrate voltage being equal to a voltage value of the substrate terminal of the first transistor (T1); and
a second buffer (45), which is connected to the substrate terminal of the second transistor (T2) and outputs a second substrate voltage, a value of the second substrate voltage being equal to a voltage value of the substrate terminal of the first transistor (T1).

5. A delay circuit, comprising a delay unit and the control circuit according to any of claims 1 to 4, wherein the substrate terminal of the second transistor (T2) is coupled to a first terminal of the delay unit, the substrate terminal of the first transistor (T1) is coupled to a second terminal of the delay unit, the control unit is configured to control a change value, changing along with the first parameter, of a rising edge delay time and/or a falling edge delay time of the delay unit to be within the first range.

6. The delay circuit of claim 5, wherein the delay unit comprises an inverter, the inverter comprises a fourth transistor and a fifth transistor, the substrate terminal of the first transistor (T1) is coupled to a substrate terminal of the fourth transistor, and the substrate terminal of the second transistor (T2) is coupled to a substrate terminal of the fifth transistor.

7. The delay circuit of claim 6, wherein the fourth transistor is a P-type transistor, and the fifth transistor is an N-type transistor.

8. A control circuit, comprising a control unit (41), a first feedback unit (42), and a second feedback unit (43), wherein:
the control unit (41) comprises an inverter (411) and a constant current source (412); a first terminal of the inverter (411) is connected to ground; a first terminal of the constant-current source (412) is connected to a second terminal of the inverter (411), and a second terminal of the constant-current source (412) is connected to a second power supply end; and an input terminal of the inverter (411) is in short circuit with an output terminal of the inverter (411) and wherein the inverter comprises a first transistor (T1) and a second transistor (T2);
the first feedback unit (42) comprises a first operational amplifier (421), wherein the negative input of the first operational amplifier (421) is connected to the second terminal of the inverter (411); the positive input of the first operational amplifier (421) is connected to a first reference voltage and the output of the first operational amplifier (421) is connected to a thr substrate terminal of the first transistor (T1) and a first terminal of a first resistor (R1);
the second feedback unit (43) comprises a second operational amplifier (431), the first resistor (R1), a second resistor (R2) and a third transistor (T3), wherein the positive input of the second operational amplifier (431) is connected to the second terminal of the first resistor (R1) and a first terminal of the second resistor (R2); the negative input of the second operational amplifier (431) is connected to a second reference voltage; the second terminal of the second resistor (R2) is connected to the substrate terminal of the second transistor (T2) and to a first terminal of the third transistor (T3); and the output of the second operational amplifier (431) is connected to the gate of the third transistor (T3), whereby the second terminal of the third transistor (T3) is connected to the ground;
and wherein,
the control circuit is configured to adjust the substrate voltage of the first transistor (T1) according to the output voltage of the first operational amplifier (421) and adjust the substrate voltage of the second transistor (T2) according to the output voltage of the second operational amplifier (431) to make a change value, changing along with a first parameter, of a current of the control unit (41) be within a first range; the first parameter comprises at least one of manufacturing process, power supply voltage, or working temperature of the control circuit.

9. The control circuit of claim 8, wherein the first terminal of the first transistor (T1) is connected to the first terminal of the constant-current source (412), a second terminal of the first transistor (T1) is connected to a first terminal of the second transistor (T2), a control terminal of the first transistor (T1) is connected to a control terminal of the second transistor (T2), and a second terminal of the second transistor (T2) is connected to the ground.

10. The control circuit of claim 8, wherein the first transistor (T1) is a P-type transistor, and the second transistor (T2) is an N-type transistor.

11. A delay circuit, comprising a delay unit and the control circuit according to any of claims 8 to 10, wherein the substrate terminal of the first transistor (T1) is coupled to a first terminal of the delay unit, the substrate terminal of the second transistor (T2) is coupled to a second terminal of the delay unit, the control unit is configured to control a change value, changing along with the first parameter, of a rising edge delay time and/or a falling edge delay time of the delay unit to be within the first range.

## Patentansprüche

1. Eine Steuerschaltung, die eine Steuereinheit (41), eine erste Rückkopplungseinheit (42) und eine zweite Rückkopplungseinheit (43) umfasst, wobei:
die Steuereinheit (41) einen Wechselrichter (411) und eine Konstantstromquelle (412) umfasst; ein erster Anschluss des Wechselrichters (411) mit einem ersten Stromversorgungsende verbunden ist; ein erster Anschluss der Konstantstromquelle (412) mit einem zweiten Anschluss des Wechselrichters (411) verbunden ist, und ein zweiter Anschluss der Konstantstromquelle (412) mit einem negativen Stromversorgungsende verbunden ist; und ein Eingangsanschluss des Wechselrichters (411) mit einem Ausgangsanschluss des Wechselrichters (411) kurzgeschlossen ist, und wobei der Wechselrichter einen ersten Transistor (T1) und einen zweiten Transistor (T2) umfasst;
die erste Rückkopplungseinheit (42) einen ersten Operationsverstärker (421) umfasst, wobei der negative Eingang des ersten Operationsverstärkers (421) mit dem zweiten Anschluss des Wechselrichters (411) verbunden ist; der positive Eingang des ersten Operationsverstärkers (421) mit einer ersten Referenzspannung verbunden ist und der Ausgang des ersten Operationsverstärkers (421) mit einem Substratanschluss des zweiten Transistors (T2) und einem ersten Anschluss eines ersten Widerstandes (R2) verbunden ist;
die zweite Rückkopplungseinheit (43) einen zweiten Operationsverstärker (431), den ersten Widerstand (R2), einen zweiten Widerstand (R1) und einen dritten Transistor (T3) umfasst, wobei der positive Eingang des zweiten Operationsverstärkers (431) mit dem zweiten Anschluss des ersten Widerstands (R2) und einem ersten Anschluss des zweiten Widerstands (R1) verbunden ist;
der negative Eingang des zweiten Operationsverstärkers (431) mit einer zweiten Referenzspannung verbunden ist; der zweite Anschluss des zweiten Widerstands (R1) mit dem Substratanschluss des ersten Transistors (T1) und mit einem ersten Anschluss des dritten Transistors (T3) verbunden ist;
und der Ausgang des zweiten Operationsverstärkers (431) mit dem Gate des dritten Transistors (T3) verbunden ist, wobei der zweite Anschluss des dritten Transistors (T3) mit dem ersten Stromversorgungsende verbunden ist;
und wobei:
die Steuerschaltung so konfiguriert ist, dass sie die Substratspannung des ersten Transistors (T1) entsprechend der Ausgangsspannung des zweiten Operationsverstärkers (431) einstellt und die Substratspannung des zweiten Transistors (T2) entsprechend der Ausgangsspannung des ersten Operationsverstärkers (421) einstellt, um einen Änderungswert eines Stroms der Steuereinheit (41), der sich zusammen mit einem ersten Parameter ändert, innerhalb eines ersten Bereichs liegen zu lassen; wobei der erste Parameter mindestens einen der folgenden Parameter umfasst: Herstellungsprozess, Stromversorgungsspannung oder Betriebstemperatur der Steuerschaltung.

2. Steuerschaltung nach Anspruch 1, wobei ein erster Anschluss des ersten Transistors (T1) mit dem ersten Stromversorgungsende verbunden ist, ein zweiter Anschluss des ersten Transistors (T1) mit einem ersten Anschluss des zweiten Transistors (T2) verbunden ist, ein Steueranschluss des ersten Transistors (T1) mit einem Steueranschluss des zweiten Transistors (T2) verbunden ist und ein zweiter Anschluss des zweiten Transistors (T2) mit dem ersten Anschluss der Konstantstromquelle (412) verbunden ist.

3. Steuerschaltung nach Anspruch 1, wobei der erste Transistor (T1) ein P-Typ-Transistor ist und der zweite Transistor (T2) ein N-Typ-Transistor ist.

4. Steuerschaltung nach Anspruch 1, ferner umfassend:
einen ersten Puffer (44), der mit dem Substratanschluss des ersten Transistors (T1) verbunden ist und eine erste Substratspannung ausgibt, wobei ein Wert der ersten Substratspannung gleich einem Spannungswert des Substratanschlusses des ersten Transistors (T1) ist; und
einen zweiten Puffer (45), der mit dem Substratanschluss des zweiten Transistors (T2) verbunden ist und eine zweite Substratspannung ausgibt, wobei ein Wert der zweiten Substratspannung gleich einem Spannungswert des Substratanschlusses des ersten Transistors (T1) ist.

5. Verzögerungsschaltung, die eine Verzögerungseinheit und die Steuerschaltung nach einem der Ansprüche 1 bis 4 umfasst, wobei der Substratanschluss des zweiten Transistors (T2) mit einem ersten Anschluss der Verzögerungseinheit gekoppelt ist, der Substratanschluss des ersten Transistors (T1) mit einem zweiten Anschluss der Verzögerungseinheit gekoppelt ist, die Steuereinheit so konfiguriert ist, dass sie einen Änderungswert, der sich zusammen mit dem ersten Parameter einer Anstiegsflanken-Verzögerungszeit und/oder einer Abfallflanken-Verzögerungszeit der Verzögerungseinheit ändert so steuert, dass er innerhalb des ersten Bereichs liegt.

6. Verzögerungsschaltung nach Anspruch 5, wobei die Verzögerungseinheit einen Wechselrichter umfasst, der Wechselrichter einen vierten Transistor und einen fünften Transistor umfasst, der Substratanschluss des ersten Transistors (T1) mit einem Substratanschluss des vierten Transistors gekoppelt ist, und der Substratanschluss des zweiten Transistors (T2) mit einem Substratanschluss des fünften Transistors gekoppelt ist.

7. Verzögerungsschaltung nach Anspruch 6, wobei der vierte Transistor ein P-Typ-Transistor ist und der fünfte Transistor ein N-Typ-Transistor ist.

8. Eine Steuerschaltung, die eine Steuereinheit (41), eine erste Rückkopplungseinheit (42) und eine zweite Rückkopplungseinheit (43) umfasst, wobei:
die Steuereinheit (41) einen Wechselrichter (411) und eine Konstantstromquelle (412) umfasst; ein erster Anschluss des Wechselrichters (411) mit Masse verbunden ist; ein erster Anschluss der Konstantstromquelle (412) mit einem zweiten Anschluss des Wechselrichters (411) verbunden ist, und ein zweiter Anschluss der Konstantstromquelle (412) mit einem zweiten Stromversorgungsende verbunden ist; und ein Eingangsanschluss des Wechselrichters (411) mit einem Ausgangsanschluss des Wechselrichters (411) kurzgeschlossen ist, und wobei der Wechselrichter einen ersten Transistor (T1) und einen zweiten Transistor (T2) umfasst;
die erste Rückkopplungseinheit (42) einen ersten Operationsverstärker (421) umfasst, wobei der negative Eingang des ersten Operationsverstärkers (421) mit dem zweiten Anschluss des Wechselrichters (411) verbunden ist; der positive Eingang des ersten Operationsverstärkers (421) mit einer ersten Referenzspannung verbunden ist und der Ausgang des ersten Operationsverstärkers (421) mit einem Substratanschluss des ersten Transistors (T1) und einem ersten Anschluss eines ersten Widerstandes (R1) verbunden ist;
die zweite Rückkopplungseinheit (43) einen zweiten Operationsverstärker (431), den ersten Widerstand (R1), einen zweiten Widerstand (R2) und einen dritten Transistor (T3) umfasst, wobei der positive Eingang des zweiten Operationsverstärkers (431) mit dem zweiten Anschluss des ersten Widerstands (R1) und einem ersten Anschluss des zweiten Widerstands (R2) verbunden ist; der negative Eingang des zweiten Operationsverstärkers (431) mit einer zweiten Referenzspannung verbunden ist; der zweite Anschluss des zweiten Widerstands (R2) ist mit dem Substratanschluss des zweiten Transistors (T2) und mit einem ersten Anschluss des dritten Transistors (T3) verbunden; und der Ausgang des zweiten Operationsverstärkers (431) ist mit dem Gate des dritten Transistors (T3) verbunden, wobei der zweite Anschluss des dritten Transistors (T3) mit der Masse verbunden ist;
und wobei:
die Steuerschaltung so konfiguriert ist, dass sie die Substratspannung des ersten Transistors (T1) entsprechend der Ausgangsspannung des ersten Operationsverstärkers (421) einstellt und die Substratspannung des zweiten Transistors (T2) entsprechend der Ausgangsspannung des zweiten Operationsverstärkers (431) einstellt, um einen Änderungswert einzustellen, der sich zusammen mit einem ersten Parameter eines Stroms der Steuereinheit (41) innerhalb eines ersten Bereichs ändert; wobei der erste Parameter mindestens eines von Herstellungsverfahren, Stromversorgungsspannung oder Betriebstemperatur der Steuerschaltung umfasst.

9. Steuerschaltung nach Anspruch 8, wobei der erste Anschluss des ersten Transistors (T1) mit dem ersten Anschluss der Konstantstromquelle (412) verbunden ist, ein zweiter Anschluss des ersten Transistors (T1) mit einem ersten Anschluss des zweiten Transistors (T2) verbunden ist, ein Steueranschluss des ersten Transistors (T1) mit einem Steueranschluss des zweiten Transistors (T2) verbunden ist und ein zweiter Anschluss des zweiten Transistors (T2) mit der Masse verbunden ist.

10. Steuerschaltung nach Anspruch 8, wobei der erste Transistor (T1) ein P-Typ-Transistor ist und der zweite Transistor (T2) ein N-Typ-Transistor ist.

11. Verzögerungsschaltung, die eine Verzögerungseinheit und die Steuerschaltung nach einem der Ansprüche 8 bis 10 umfasst, wobei der Substratanschluss des ersten Transistors (T1) mit einem ersten Anschluss der Verzögerungseinheit gekoppelt ist, der Substratanschluss des zweiten Transistors (T2) mit einem zweiten Anschluss der Verzögerungseinheit gekoppelt ist, die Steuereinheit so konfiguriert ist, dass sie einen Änderungswert einer Anstiegsflanken-Verzögerungszeit und/oder einer Abfallflanken-Verzögerungszeit der Verzögerungseinheit, der sich zusammen mit dem ersten Parameter ändert, so steuert, dass er innerhalb des ersten Bereichs liegt.

## Revendications

1. Circuit de commande comprenant une unité de commande (41), une première unité de rétroaction (42) et une deuxième unité de rétroaction (43), dans lequel :
l'unité de commande (41) comprend un onduleur (411) et une source de courant constant (412) ; une première borne de l'onduleur (411) est connectée à une première extrémité d'alimentation électrique ; une première borne de la source de courant constant (412) est connectée à une deuxième borne de l'onduleur (411), et une deuxième borne de la source de courant constant (412) est connectée à une extrémité d'alimentation électrique négative ; et une borne d'entrée de l'onduleur (411) est en court-circuit avec une borne de sortie de l'onduleur (411) et dans lequel l'onduleur comprend un premier transistor (T1) et un deuxième transistor (T2) ;
la première unité de rétroaction (42) comprend un premier amplificateur opérationnel (421), dans lequel l'entrée négative du premier amplificateur opérationnel (421) est connectée à la deuxième borne de l'onduleur (411) ; l'entrée positive du premier amplificateur opérationnel (421) est connectée à une première tension de référence et la sortie du premier amplificateur opérationnel (421) est connectée à une borne de substrat du deuxième transistor (T2) et à une première borne d'une première résistance (R2) ;
la deuxième unité de rétroaction (43) comprend un deuxième amplificateur opérationnel (431), la première résistance (R2), une deuxième résistance (R1) et un troisième transistor (T3), dans lequel l'entrée positive du deuxième amplificateur opérationnel (431) est connectée à la deuxième borne de la première résistance (R2) et à une première borne de la deuxième résistance (R1);
l'entrée négative du deuxième amplificateur opérationnel (431) est connectée à une deuxième tension de référence ; la deuxième borne de la deuxième résistance (R1) est connectée à la borne de substrat du premier transistor (T1) et à une première borne du troisième transistor (T3) ;
et la sortie du deuxième amplificateur opérationnel (431) est connectée à la grille du troisième transistor (T3), la deuxième borne du troisième transistor (T3) étant connectée à la première extrémité d'alimentation électrique ;
et dans lequel,
le circuit de commande est configuré pour ajuster la tension de substrat du premier transistor (T1) en fonction de la tension de sortie du deuxième amplificateur opérationnel (431) et ajuster la tension de substrat du deuxième transistor (T2) en fonction de la tension de sortie du premier amplificateur opérationnel (421) afin qu'une valeur de changement, changeant en même temps qu'un premier paramètre, d'un courant de l'unité de commande (41) se situe dans une première plage ; le premier paramètre comprend au moins l'un d'un processus de fabrication, d'une tension d'alimentation ou d'une température de fonctionnement du circuit de commande.

2. Circuit de commande selon la revendication 1, dans lequel une première borne du premier transistor (T1) est connectée à la première extrémité d'alimentation électrique, une deuxième borne du premier transistor (T1) est connectée à une première borne du deuxième transistor (T2), une borne de commande du premier transistor (T1) est connectée à une borne de commande du deuxième transistor (T2), et une deuxième borne du deuxième transistor (T2) est connectée à la première borne de la source de courant constant (412).

3. Circuit de commande selon la revendication 1, dans lequel le premier transistor (T1) est un transistor de type P, et le deuxième transistor (T2) est un transistor de type N.

4. Circuit de commande selon la revendication 1, comprenant en outre :
un premier tampon (44), qui est connecté à la borne de substrat du premier transistor (T1) et délivre une première tension de substrat, une valeur de la première tension de substrat étant égale à une valeur de tension de la borne de substrat du premier transistor (T1) ; et
un deuxième tampon (45), qui est connecté à la borne de substrat du deuxième transistor (T2) et délivre une deuxième tension de substrat, une valeur de la deuxième tension de substrat étant égale à une valeur de tension de la borne de substrat du premier transistor (T1).

5. Circuit de retard, comprenant une unité de retard et le circuit de commande selon l'une quelconque des revendications 1 à 4, dans lequel la borne de substrat du deuxième transistor (T2) est couplée à une première borne de l'unité de retard, la borne de substrat du premier transistor (T1) est couplée à une deuxième borne de l'unité de retard, l'unité de commande est configurée pour commander une valeur de changement, changeant en même temps que le premier paramètre, d'un temps de retard de front montant et/ou d'un temps de retard de front descendant de l'unité de retard pour être dans la première plage.

6. Circuit de retard selon la revendication 5, dans lequel l'unité de retard comprend un onduleur, l'onduleur comprend un quatrième transistor et un cinquième transistor, la borne de substrat du premier transistor (T1) est couplée à une borne de substrat du quatrième transistor, et la borne de substrat du deuxième transistor (T2) est couplée à une borne de substrat du cinquième transistor.

7. Circuit de retard selon la revendication 6, dans lequel le quatrième transistor est un transistor de type P, et le cinquième transistor est un transistor de type N.

8. Circuit de commande comprenant une unité de commande (41), une première unité de rétroaction (42) et une deuxième unité de rétroaction (43), dans lequel :
l'unité de commande (41) comprend un onduleur (411) et une source de courant constant (412) ; une première borne de l'onduleur (411) est connectée à la terre ; une première borne de la source de courant constant (412) est connectée à une deuxième borne de l'onduleur (411), et une deuxième borne de la source de courant constant (412) est connectée à une deuxième extrémité d'alimentation électrique ; et une borne d'entrée de l'onduleur (411) est en court-circuit avec une borne de sortie de l'onduleur (411) et dans lequel l'onduleur comprend un premier transistor (T1) et un deuxième transistor (T2) ;
la première unité de rétroaction (42) comprend un premier amplificateur opérationnel (421), dans lequel l'entrée négative du premier amplificateur opérationnel (421) est connectée à la deuxième borne de l'onduleur (411) ; l'entrée positive du premier amplificateur opérationnel (421) est connectée à une première tension de référence et la sortie du premier amplificateur opérationnel (421) est connectée à une borne de substrat du premier transistor (T1) et à une première borne d'une première résistance (R1) ;
la deuxième unité de rétroaction (43) comprend un deuxième amplificateur opérationnel (431), la première résistance (R1), une deuxième résistance (R2) et un troisième transistor (T3), dans lequel l'entrée positive du deuxième amplificateur opérationnel (431) est connectée à la deuxième borne de la première résistance (R1) et à une première borne de la deuxième résistance (R2) ; l'entrée négative du deuxième amplificateur opérationnel (431) est connectée à une deuxième tension de référence ; la deuxième borne de la deuxième résistance (R2) est connectée à la borne de substrat du deuxième transistor (T2) et à une première borne du troisième transistor (T3) ; et la sortie du deuxième amplificateur opérationnel (431) est connectée à la grille du troisième transistor (T3), la deuxième borne du troisième transistor (T3) étant connectée à la masse ;
et dans lequel,
le circuit de commande est configuré pour ajuster la tension de substrat du premier transistor (T1) en fonction de la tension de sortie du premier amplificateur opérationnel (421) et ajuster la tension de substrat du deuxième transistor (T2) en fonction de la tension de sortie du deuxième amplificateur opérationnel (431) afin qu'une valeur de changement, changeant en même temps qu'un premier paramètre, d'un courant de l'unité de commande (41) se situe dans une première plage ; le premier paramètre comprend au moins l'un d'un processus de fabrication, d'une tension d'alimentation ou d'une température de fonctionnement du circuit de commande.

9. Circuit de commande selon la revendication 8, dans lequel la première borne du premier transistor (T1) est connectée à la première borne de la source de courant constant (412), une deuxième borne du premier transistor (T1) est connectée à une première borne du deuxième transistor (T2), une borne de commande du premier transistor (T1) est connectée à une borne de commande du deuxième transistor (T2), et une deuxième borne du deuxième transistor (T2) est connectée à la masse.

10. Circuit de commande selon la revendication 8, dans lequel le premier transistor (T1) est un transistor de type P, et le deuxième transistor (T2) est un transistor de type N.

11. Circuit de retard, comprenant une unité de retard et le circuit de commande selon l'une quelconque des revendications 8 à 10, dans lequel la borne de substrat du premier transistor (T1) est couplée à une première borne de l'unité de retard, la borne de substrat du deuxième transistor (T2) est couplée à une deuxième borne de l'unité de retard, l'unité de commande est configurée pour commander une valeur de changement, changeant en même temps que le premier paramètre, d'un temps de retard de front montant et/ou d'un temps de retard de front descendant de l'unité de retard pour être dans la première plage.
